(19) Europäisches Patentamt
European Patent Office
Office européen des brevets

(11) EP 3 855 523 A1

(12) EUROPEAN PATENT APPLICATION

(43) Date of publication:
**28.07.2021 Bulletin 2021/30**

(21) Application number: **21152355.0**

(22) Date of filing: **19.01.2021**

(51) Int Cl.:
***H01L 51/44*** *(2006.01)* ***H01L 51/46*** *(2006.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **22.01.2020 JP 2020008114**

(71) Applicant: **Ricoh Company, Ltd.**
**Tokyo 143-8555 (JP)**

(72) Inventors:
- **HIRANO, Tomoya**
  **Tokyo, 143-8555 (JP)**
- **ARAI, Ryota**
  **Tokyo, 143-8555 (JP)**
- **ITO, Takaya**
  **Tokyo, 143-8555 (JP)**

(74) Representative: **Fairbairn, Angus Chisholm**
**Marks & Clerk LLP**
**15 Fetter Lane**
**London EC4A 1BW (GB)**

# (54) PHOTOELECTRIC CONVERTER, PHOTOELECTRIC CONVERSION MODULE, ELECTRONIC DEVICE, AND POWER SOURCE MODULE

(57) A photoelectric converter (1) includes a substrate (2), a first electrode (3) on the substrate (2), an electron transport layer (4) overlying the first electrode (3), a photoelectric conversion layer (5) overlying the electron transport layer (4), the photoelectric conversion layer (5) containing at least two types of organic materials, a hole transport layer (6) overlying the photoelectric conversion layer (5), and a second electrode (7) overlying the hole transport layer (6), wherein the photoelectric converter (1) has a ratio $P_L$ of current leakage of 0.95 or less at an illuminance of 200 lux, where the ratio $P_L$ is calculated from the following equation (1):

$$P_L = L/J_{ph} \quad \text{Equation (1),}$$ equation (1),

where L represents a density (μA/cm$^2$) of current leakage at an illuminance of 200 lux and $J_{ph}$ represents a density (μA/cm$^2$) of photocurrent density at an illuminance of 200 lux.

FIG. 1

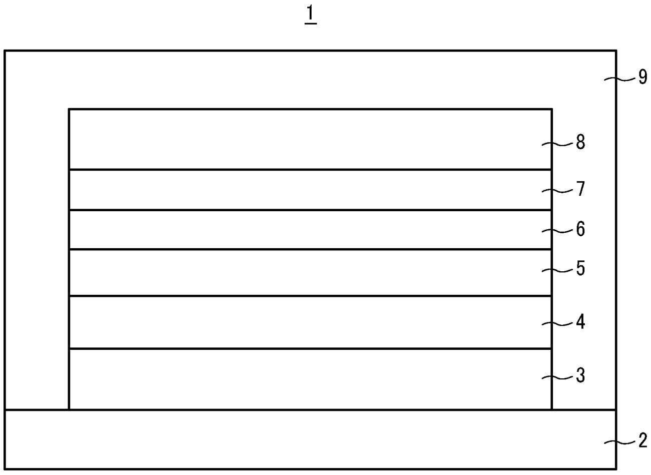


EP 3 855 523 A1

## Description

BACKGROUND

Technical Field

The present disclosure relates to a photoelectric converter, a photoelectric conversion module, an electronic device, and a power source module.

Description of the Related Art

Internet of Things (IOT) is expected to be a way of comprehensively controlling the society system by connecting all things to the Internet. Before such an IOT society is realized, many sensors need to be connected to all kinds of things to acquire data and power supplies to operate sensors; it is, however, not practical to wire many sensors and use many rechargeable batteries. Energy harvesting elements for power source are expected to reduce the burden on the environment, which is a great concern of society.

Of such elements, photoelectric converters are appealing because they can generate electricity anywhere upon application of light. Flexible photoelectric converters, in particular, are required to be highly efficient. They are expected to be traceable to curved surfaces and applicable to wearable devices. Feasibility on these applications was discussed and reported in Applied Physics letters 108,253301 (published in 2016) and Japanese Journal of Applied Physics 54,071602 (published in 2015).

Organic thin film solar cells are expected to be highly efficient and flexible energy harvesting elements. One example of such elements is a photoelectric converter having a transparent substrate film as a substrate, which has been proposed in JP-2014-220333-A1.

A housing for mobile electronic device has been proposed in JP-2016-208568-A1 which includes a solar cell module to efficiently generate electricity with a mobile electronic device even when the output voltage of the solar cell module lowers. Its attributes are that the decrease of the voltage at the open-circuit voltage is 0.2 V or less when the irradiance lowers from 100 to 1 $mW/cm^2$ in the relationship between the illuminance and the open-circuit voltage, and the open-circuit voltage is 0.55 V or more at an irradiance of 1.0 $W/cm^2$, when the module is measured with a solar simulator under conditions of an airmass (AM) of 1.5 and a temperature of the solar cell module of 25 degrees C with a light entering direction perpendicular to the cell.

SUMMARY

According to the present disclosure, a photoelectric converter is provided which achieves excellent photoelectric conversion even in low illumination environment in comparison with a high illumination environment.

According to embodiments of the present disclosure, a photoelectric converter (1) is provided which includes a substrate (2), a first electrode (3) on the substrate (2), an electron transport layer (4) overlying the first electrode (3), a photoelectric conversion layer (5) overlying the electron transport layer (4), the photoelectric conversion layer (5) containing at least two types of organic materials, a hole transport layer (6) overlying the photoelectric conversion layer (5), and a second electrode (7) overlying the hole transport layer (6), wherein the photoelectric converter (1) has a ratio $P_L$ of current leakage of 0.95 or less at an illuminance of 200 lux, where the ratio $P_L$ is calculated from the following equation (1): $P_L = L/J_{ph}$ Equation (1), where L represents a density ($\mu A/cm^2$) of current leakage at an illuminance of 200 lux and $J_{ph}$ represents a density ($\mu A/cm^2$) of photocurrent density at an illuminance of 200 lux.

BRIEF DESCRIPTION OF THE SEVERAL VIEWS OF THE DRAWINGS

Various other objects, features and attendant advantages of the present invention will be more fully appreciated as the same becomes better understood from the detailed description when considered in connection with the accompanying drawings in which like reference characters designate like corresponding parts throughout and wherein:

FIG. 1 is a diagram illustrating an organic thin film solar cell as an example of the photoelectric converter according to an embodiment of the present disclosure;
FIG. 2 is a graph plotting the open-circuit voltage $V_{oc}$ (V) per cell to In ($J_{ph}$);
FIG. 3 is a block diagram illustrating a mouse for computer as an example of the electronic device according to an embodiment of the present disclosure;
FIG. 4 is a schematic diagram illustrating an example of the mouse illustrated in FIG. 3;
FIG. 5 is a block chart illustrating a keyboard for computer as an example of the electronic device according to an

embodiment of the present disclosure;

FIG. 6 is a schematic diagram illustrating an example of the keyboard illustrated in FIG. 5,

FIG. 7 is a schematic diagram illustrating another example of the keyboard illustrated in FIG. 5;

FIG. 8 is a block diagram illustrating a sensor as an example of the electronic device according to an embodiment of the present disclosure;

FIG. 9 is a block diagram illustrating a turntable as an example of the electronic device according to an embodiment of the present disclosure;

FIG. 10 is a block diagram illustrating an example of the electronic device according to an embodiment of the present disclosure;

FIG. 11 is a block diagram illustrating an example in which a power control IC is incorporated into the electronic device illustrated in FIG. 10;

FIG. 12 is a block diagram illustrating an example in which a rechargeable device is further incorporated into the electronic device illustrated in FIG. 11;

FIG. 13 is a block diagram illustrating an example of the power source module according to an embodiment of the present disclosure; and

FIG. 14 is a block diagram illustrating an example in which a rechargeable device is incorporated into the power source module illustrated in FIG. 13.

The accompanying drawings are intended to depict example embodiments of the present invention and should not be interpreted to limit the scope thereof. The accompanying drawings are not to be considered as drawn to scale unless explicitly noted. Also, identical or similar reference numerals designate identical or similar components throughout the several views.

DESCRIPTION OF THE EMBODIMENTS

In describing embodiments illustrated in the drawings, specific terminology is employed for the sake of clarity. However, the disclosure of this specification is not intended to be limited to the specific terminology so selected and it is to be understood that each specific element includes all technical equivalents that have a similar function, operate in a similar manner, and achieve a similar result.

As used herein, the singular forms "a", "an", and "the" are intended to include the plural forms as well, unless the context clearly indicates otherwise.

Moreover, image forming, recording, printing, modeling, etc., in the present disclosure represent the same meaning, unless otherwise specified.

Embodiments of the present invention are described in detail below with reference to accompanying drawing(s). In describing embodiments illustrated in the drawing(s), specific terminology is employed for the sake of clarity. However, the disclosure of this patent specification is not intended to be limited to the specific terminology so selected, and it is to be understood that each specific element includes all technical equivalents that have a similar function, operate in a similar manner, and achieve a similar result.

For the sake of simplicity, the same reference number will be given to identical constituent elements such as parts and materials having the same functions and redundant descriptions thereof omitted unless otherwise stated.

Within the context of the present disclosure, if a first layer is stated to be "overlaid" on, or "overlying" a second layer, the first layer may be in direct contact with a portion or all of the second layer, or there may be one or more intervening layers between the first and second layer, with the second layer being closer to the substrate than the first layer.

Photoelectric converter

The photoelectric converter includes a substrate, a first electrode on the substrate, an electron transport layer overlying the first electrode, a photoelectric conversion layer overlying the first electrode, the photoelectric conversion layer containing at least two types of organic materials, a hole transport layer overlying the photoelectric conversion layer, and a second electrode overlying the hole transport layer, wherein the photoelectric converter has a ratio $P_L$ of current leakage of 0.95 or less at an illuminance of 200 lux, where the ratio $P_L$ is calculated from the following equation (1):

$$P_L = L/J_{ph} \quad \text{Equation (1).}$$

In the equation (1), L represents a density ($\mu A/cm^2$) of current leakage at an illuminance of 200 lux and $J_{ph}$ represents a density ($\mu A/cm^2$) of photocurrent at an illuminance of 200 lux.

In the specification of the present disclosure, "photoelectric converter" means an element that converts light

energy into electric energy or the other way round and includes a solar cell and a photodiode.

An organic thin film solar cells as an example of the photoelectric converter can be readily made flexible in comparison with an inorganic solar cell, which uses an inorganic crystalline material such as crystal silicon; it is, however, necessary to make the photoelectric conversion layer in an organic thin film solar cell thinner to achieve sufficient attributes because the photoelectric conversion layer is composed of an organic material having a smaller diffusion length of a carrier than an inorganic crystalline material. The average thickness of a photoelectric conversion layer made of organic materials is in general around several hundred nanometers. This average thickness is extremely thinner than that of a crystalline silicon solar cell, which is an order of micro meter; it is necessary to secure a uniform thickness of such a thin photoelectric conversion layer when it is formed by a solution process in particular. The solution process is used in general to form layers including the photoelectric conversion layer because the process is cost effective. However, if a non-uniform photoelectric conversion layer is formed owing to the malformation of film or the presence of impurities, the electron transport layer and the hole transport layer contact each other and moreover, the first electrode and the second electrode directly contact each other; the current is leaked from portions having a low resistance. Such current leakage damages the attributes of the photoelectric conversion of the organic thin film solar cell. What impact this leakage has on the attributes of photoelectric conversion is known to be dependent on the amount of light entering into an organic thin film solar cell; the attributes of photoelectric conversion deteriorate as the amount of light decreases.

In fact, even an organic thin film solar cell having a certain level of photoelectric conversion attributes in an environment of a relatively large amount of light such as reference sunlight reduces the output power more than the decreases in the input energy in an environment of a small amount of light such as indoor environment. The attributes of a photoelectric converter including an organic thin film solar cell can be evaluated by the following three parameters: Jsc, the density (A/$cm^2$) of short circuit current in which the photoelectric converter is short-circuited; Voc (V) of open-circuit voltage of a photoelectric converter at an open state; and FF, the curve factor of voltage-current curve. The energy conversion efficiency $\eta$ against the incident light energy Pin (W/$cm^2$) is represented by the following equation (2).

$$\eta = J_{SC} \text{ x } V_{OC} \text{ X } FF/P_{in} \qquad (2)$$

JP-2016-208568-A1 regulates the condition for the open-circuit voltage value of a photoelectric converter capable of efficiently generating electricity without a significant drop of the output power in a low illumination; it is, however, just a limitation on the voltage supplied to a photoelectric converter to operate a mobile device. There is no suggestion or discussion about the mechanism of the attributes of a photoelectric converter deteriorating in an environment of a low illumination or what factor should be controlled to reduce the deterioration.

As described above, an organic thin film solar cell as an example of the photoelectric converter is required to be thin in principle. Such a thin film causes a drawback such as current leakage. This current leakage causes a problem of a drop of the output power in particular in an low illumination environment such as indoor light. The present inventors have formulated a solution to the problem, which is controlling the relative ratio (ratio of current leakage) of the density of current leakage to the density of photocurrent.

An environment of illumination light including visible light is assumed for the photoelectric converter of the present disclosure. Since illuminance (lux) is used to indicate the amount of light in general, illuminance is regulated in the present disclosure. As the reference illuminance, the reference of minimum illuminance in each environment is regulated in JIS Z 9110:2010 format. Normal visual operation in an ordinary manufacturing factory requires at least 500 lux and other types of operations at a warehouse require at least 200 lux. On the other hand, 1 SUN as the reference sunlight is about 100,000 lux and known to be by several hundreds to several thousands larger than the illuminance in an indoor environment.

Having investigated photoelectric converters having a high energy conversion efficiency in an environment of a small light amount such as in indoor light environment without significantly deteriorating from that in an environment of a relatively large light amount, the present inventors have focused on the current leakage mentioned above.

As a result of the investigation on the current leakage, the present inventors have acquired the knowledge that the photoelectric conversion of a photoelectric converter deteriorate in an environment of low illumination such as indoor environment when the relative ratio of the density of the current leakage to the density of photocurrent surpasses a certain level. The present inventors have found that the density of the current leakage is necessary to decrease to obtain a photoelectric converter having a high photoelectric conversion in an environment of low illumination. The present disclosure was thus made.

The photoelectric converter of the present disclosure includes at least a substrate, a first electrode on the substrate, an electron transport layer, a photoelectric conversion layer, a photoelectric conversion layer containing at least two types of organic materials, a hole transport layer, a second electrode, wherein the photoelectric converter has a ratio $P_L$ of current leakage of 0.95 or less at an illuminance of 200 lux, where the ratio $P_L$ is calculated from the following equation (1):

$$P_L = L/J_{ph} \quad \text{Equation (1).}$$

In the equation (1), L represents a density (μA/cm$^2$) of current leakage at an illuminance of 200 lux and $J_{ph}$ represents a density (μA/cm$^2$) of photocurrent density at an illuminance of 200 lux.

The device evaluation and the current leakage ratio $P_L$ are obtained in the following manner.

Evaluation on Device and Calculation of Ratio $P_L$ of Current Leakage

The current-voltage attribute is measured changing the illuminance of light to which a device is exposed with a source meter capable of measuring the density of short circuit current and the open-circuit voltage of a target photoelectric converter in an arbitrary illumination. It is preferable to use the same light source regardless of illuminance, yet it is possible to use another illumination when using the same light source is difficult as long as the difference in the color temperatures between the two illuminations is within an absolute value of 200 K.

The ratio $P_L$ of current leakage at an illuminance of 200 lux can be calculated from the following equation (1):

$$P_L = L/J_{ph} \quad \text{Equation (1).}$$

In the equation (1), L represents a density (μA/cm$^2$) of current leakage at an illuminance of 200 lux and $J_{ph}$ represents a density (μA/cm$^2$) of photocurrent at an illuminance of 200 lux.

The density L (μA/cm$^2$) of current leakage at an illuminace of 200 lux can be obtained by assigning the values of the density Jsc (μA/cm$^2$) of short circuit current and the open-circuit voltage Voc (V) per cell obtained at the measurements at an illuminance of 200 lux into the following equation (3).

$$L = J_{ph} - \mathrm{J_0}\left\{\exp\left(\frac{qV_{oc}}{\mathrm{nkT}}\right) - 1\right\} \quad (3)$$

In the equation (3), $J_{ph}$ represents the density (μA/cm$^2$) of photocurrent. Hereinafter, it is treated as equal to Jsc for convenience. Jo represents the density (μA/cm$^2$) of dark current, q represents elementary charge (= 1.602 × $10^{-19}$ C), n represents ideality factor, k represents Boltzmann's constant (= 1.38 × $10^{-23}$ cm$^2$•kg•s$^{-2}$•K$^{-1}$), and T represents the temperature (K) of a device.

In the case of a photoelectric conversion module in which multiple cells are connected in series, the value obtained by dividing the open-circuit voltage Voc_mod of the entire module by the number of series $N_{mod}$ is defined as Voc as shown in the following equation (4).

$$V_{OC} = V_{OC_mod}/N_{mod} \quad (4)$$

Jo and n in the equation (3) are values calculated from $V_{OC}$ - 1n($J_{ph}$) plotting obtained by measurements at three or more points arbitrarily-selected from 2,000 to 20,000 lux realized at the illumination mentioned above. FIG. 2 is a graph illustrating an example of plotting Voc - 1n($J_{ph}$).

The plots can be approximate to a straight line when the density of current leakage mentioned above is sufficiently small. When the decline of the regression line obtained by the least squares method is defined as m and the intercept against the 1n($J_{ph}$) axis is defined as 1n($J_O$) regarding the points corresponding to the measurements at the three or more points, n can be obtained from the following equation (5) and $J_O$ can be obtained from the axis intercept. The coefficient of determination of the regression line is preferably 0.99 or greater.

$$n = \frac{qm}{kT} \quad (5)$$

n normally ranges from 1 to 2. When n surpasses 2 or $J_O$ calculated by the method described above surpasses 0.01 (μA/cm$^2$), the ratio $P_L$ of current leakage cannot be correctly calculated by the method mentioned above because the current leakage is extremely large. The current leakage ratio in this case is at least above 0.95. Conversely, when the density of current leakage is extremely small, the density of current leakage may be negative owing to the measuring

error. In such a case, the density of current leakage is regarded as 0 ($\mu A/cm^2$).

The way or condition of preparing the photoelectric converter satisfying the requisite of the ratio $P_L$ of current leakage of 0.95 or less is not particularly limited and can be suitably selected to suit to a particular application. It includes, for example, the following (1) to (4).

(1) A photoelectric converter includes a substrate, a first electrode on the substrate, an electron transport layer on the first electrode, a photoelectric conversion layer on the first electrode, the photoelectric conversion layer containing at least two types of organic materials, a hole transport layer on the photoelectric conversion layer, a second electrode on the hole transport layer, and an insulating layer on the second electrode, wherein the first electrode contains a transparent electroconductive film, wherein the following relationship is satisfied: $7.0 \leqq T/D$, where T represents the average thickness of the photoelectric conversion layer and D represents the average particle diameter of the metal oxide particles.

(2) The surface of the first electrode is preferably smooth. The surface roughness Ra is preferably less than 10 nm. The surface is preferably free of impurities. If the surface of the first electrode is not sufficiently smooth or impurities are present on the surface of the first electrode, the surface of film formed on the first electrode becomes rough. Such a rough surface may increase the density of the current leakage.

Impurities can be removed by: dipping a substrate on which the first electrode is formed in a liquid such as a rinsing liquid, an organic solvent, and pure water followed by rinsing with ultrasonic wave; or subjecting the surface of the first electrode to air pressure plasma treatment or $UV\text{-}O_3$ treatment.

(3) It is preferable that the average thickness of the electron transport layer be approximately 20 nm or greater and impurities be little or never present on the surface. The agglomerated matter of the material of the electron transport layer is regarded as one of the impurities. It is preferable that the number of impurities having a diameter of 100 nm or greater on the surface of an electron transport layer be 10 or less in a region of 100 $\mu m \times 100$ $\mu m$ of the surface; impurities present on the surface of an electron transport layer may cause the surface of the photoelectric conversion layer rough and increase the density of current leakage.

Such impurities can be removed by air pressure plasma treatment to the surface of an electron transport layer or selectively burn off the impurities with laser beams in accordance with their absorption wavelengths.

(4) It is preferable that the average thickness of the photoelectric conversion layer be approximately 100 nm or greater and the variance of the thickness be minimal. It is preferable that the minimum thickness of the photoelectric conversion layer in the effective power generation region be at least 75 percent of the average thickness. If the thickness of the photoelectric conversion layer varies portion by portion, the density of the current leakage may increase owing to the mechanism described above. To reduce the variance of the thickness, the following can be optimized: the concentration of liquid application; the solvent for the liquid application; and the application method.

It is possible to achieve a ratio $P_L$ of current leakage of 0.95 or less by all of (2) to (4) mentioned above; an average thickness of the hole transport layer of 50 nm or greater can further reduce the density of current leakage.

Substrate

The substrate is transparent and flexible film or glass which is not flexible but flat.

Specific examples of the film include, but are not limited to, polyester such as polyethylene terephthalate, polycarbonate, polyimide, polymethyhlmethacrylate, polysulfone, and polyetheretherketone. The substrate includes a thin film glass having an average thickness of 200 $\mu m$ or less. Of these films, polyester, polyimide, and thin-film glass are preferable because they are readily and cost-effectively manufactured.

If a plastic substrate is used, it is preferable to provide it with a gas barrier layer.

A gas barrier is a layer for preventing transmission of vapor oxygen. A gas barrier having such a function is not particularly limited and can be suitably selected to suit to a particular application. A specific example is a plastic substrate covered with aluminum.

First Electrode

The first electrode is mainly composed of a transparent electroconductive film. The first electrode may have a structure of a transparent electroconductive film, a thin metal film layer, and a transparent electroconductive film laminated in this order.

The same or different materials can be used for the transparent electroconductive films sandwiching the thin metal film.

Specific examples of the material for use in the transparent electroconductive film include, but are not limited to, tin-doped indium oxide (ITO), zinc-doped indium oxide (IZO), zinc oxide (ZnO), aluminium-doped zinc oxide (AZO),

gallium-doped zinc oxide (GZO), and tin oxide ($S_nO_2$). Of these, ITO, IZO, and AZO are preferable.

The average thickness of the transparent electroconductive film is preferably 30 nm or greater and more preferably from 40 to 150 nm.

The transparent electrode preferably has a sheet resistance of 50 Ω/□ or less, more preferably 30 Ω/□ or less, and furthermore preferably 20 Ω/□ or less.

The transparent electrode preferably has a high level of transparency. Its transparency is preferably 60 percent or higher and more preferably 70 percent or higher. The upper limit is not particularly limited and can be suitably selected to suit to a particular application; 90 percent or less is preferable.

Charge Transport Layer

The electron transport layer is formed on or overlying the first electrode.

The electron transport layer preferably contains metal oxide particles. The layer can be formed by applying a liquid dispersion of the metal oxide particles followed by drying. The metal oxide particles preferably have an n-type semiconductor property. Particles of zinc oxide, titanium oxide, and tin oxide are preferable. The metal oxide particle may be doped with other metals.

Specific examples of the metal oxide for use in the electron transport layer include, but are not limited to, zinc oxide, aluminium-doped zinc oxide, gallium-doped zinc oxide, titanium oxide, and tin oxide.

The average particle diameter (D) of the nano-particulate metal oxide particles is preferably from 1 to 50 nm and more preferably from 5 to 20 nm.

The average thickness of the electron transport layer is preferably from 10 to 60 nm and more preferably from 15 to 40 nm.

The average particle diameter (D) of the metal oxide particles can be measured in the following manner.

A solution of the metal oxide particle is moved to a glass nebulizer with a micro pipette. The solution is sprayed from the nebulizer to a grid with collodion film for transmission electron microscopy (TEM). The grid is deposited with carbon using physical vapor deposition (PVD) method to acquire images of metal oxide particles with an electron microscope. The obtained image is subjected to image processing to measure the particle diameter of the metal oxide particles.

The cross sectional surface of the photoelectric converter is observed with a scanning TEM. Particles are recognized with image processing followed by measuring the particle diameter of the metal oxide particles. The particle size distribution can be measured by laser diffraction/scattering. The method of cross-sectional surface exposure, observation with TEM, and measuring of particle size distribution are already well-known.

In the present disclosure, the particle diameter of each of at least randomly selected hundred metal oxide particles is measured and averaged to obtain the average particle diameter of the metal oxide particles.

The electron transport layer preferably has a structure of a first electron transport layer containing the metal oxide particles and a second electron transport layer between the first electron transport layer and the photoelectric conversion layer.

The second electron transport layer preferably contains an amine compound represented by the following Chemical Formula (4).

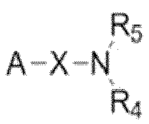

Chemical Formula (4)

In the Chemical Formula (4), $R_4$ and $R_5$ each, independently substituted or non-substituted alkyl groups having 1 to 4 carbon atoms.

X represents a divalent aromatic group having 6 to 14 carbon atoms or an alkyl group having 1 to 4 carbon atoms, $R_4$ and $R_5$ can share a linkage to form a ring. A represents one of -COOH, -P(=O)($OH_2$), and -Si$(OH)_3$.

Photoelectric conversion Layer

The photoelectric conversion layer is formed on or overlying the electron transport layer.

The photoelectric conversion layer contains two or more types of organic materials and may contain furthermore optionally other components.

One of the organic materials of the two or more types of organic materials contained in the photoelectric conversion layer is an electron donor and the others are electron acceptors. The electron donor is also referred to as a

p-type organic semiconductor material and the electron acceptor is referred to as an n-type organic material.

The photoelectric conversion layer preferably has a bulk hetero structure containing a mixture of these materials.

The type of the electron donor used is not particularly limited and can be suitably selected to suit to a particular application. The electron donor is preferably a π-electron conjugated compound having a highest occupied molecular orbital (HOMO) level of from 5.1 to 5.5 eV.

Specific examples include, but are not limited to, conjugated polymers obtained by coupling aromatic series derivatives such as thiophen, fluorene, carbazole, thienothiophene, benzodithiophene dithienosilole, quinoxaline, and benzothiadiazole, and porphyrin and phthalocyanine, which are conjugated compounds having clearly identified low molecular weights. They also include organic materials such as donor-acceptor linking materials having an electron donating portion and an electron accepting portion in the molecule.

Of these electron donors, the materials for electron donor (P-type semiconductor) made of low molecular weight conjugated compounds having a number average molecular weight of 10,000 or less are more preferable. The number average molecular weight is more preferably 5,000 or less.

Specific examples of the one of the organic materials of the two or more types of organic materials contained in the photoelectric conversion layer include, but are not limited to, compounds represented by the following Chemical Formula (1).

Specific examples of the electron donor having a highest occupied molecular orbital (HOMO) level of from 5.1 to 5.5 eV and a number average molecular weight of 10,000 or less include, but are not limited to, the compounds represented by the following Chemical Formula (1).

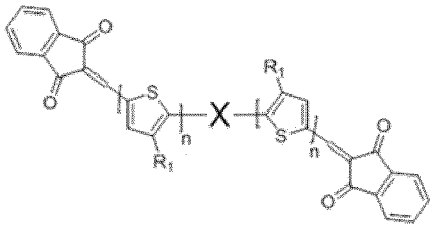

Chemical Formula (1)

In the Chemical Formula (1), $R_1$ represents an alkyl group having 2 to 8 carbon atoms. n represents an integer of from 1 to 2. X represents one of the following Chemical Formula (2) and the following Chemical Formula (3).

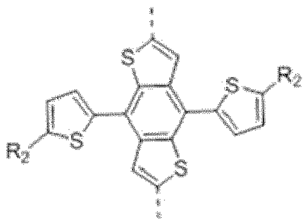

Chemical Formula (2)

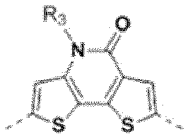

Chemical Formula (3)

In the Chemical Formulae (2) and (3), $R_2$ and $R_3$ each, independently represent linear or branched alkyl groups. The linear or branched alkyl group preferably has 2 to 30 carbon atoms.

Specific examples of the compound represented by the Chemical Formula (1) are illustrated below but are not limited thereto.

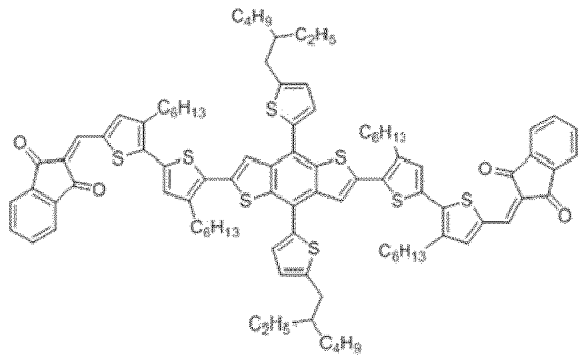

Illustrated Compound (1)

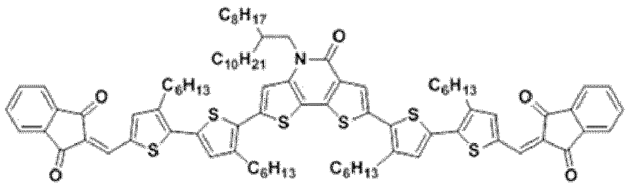

Illustrated Compound 3

The type of electron acceptor organic material as the other organic material mentioned above is not particularly limited and can be suitably selected to suit to a particular application. It is preferably a π electron conjugated compound having a lowest occupied molecular orbital (LOMO) level of from 3.5 to 4.5 eV.

Example of the other organic material are electron acceptors (N-type semiconductor) below. Specific examples include, but are not limited to, fullerene or its derivatives, naphthalene tetracarboxylic acid imide derivatives, and perylene teracarboxylic acid imide derivatives. Of these, fullerene derivatives are more preferable.

Specific examples of the fullerene derivatives include, but are not limited to, C60, phenyl-C61-methyl lactate (fullerene derivatives referred to as PCBM, [60]PCBM, or PC61BM in documents), C70, phenyl-C-71-methyl lactate (fullerene derivatives referred to as PCBM, [70]PCBM, or PC71BM in documents), and fullerene derivatives mentioned in the web site of DAIKIN INDUSTRIES, LTD.

The average thickness of the photoelectric conversion layer is preferably from 50 to 400 nm and more preferably from 60 to 250 nm. An average thickness of 50 nm or greater effectively prevents a problem of insufficient production of carriers owing to deficiency of light absorption by the photoelectric conversion layer. An average thickness of 400 nm or less effectively prevents the degradation of transport efficiency of carriers produced by light absorption

The present inventors have found that the relationship between the thicknesses of the electron transport layer and the photoelectric conversion layer have an great impact on reducing the ratio of current leakage.

When the average particle diameter of the metal oxide particles in the electron transport layer is defined as D and the average thickness of the photoelectric conversion layer is defined as T, the following relationship is satisfied: $7.0 \leqq T/D$.

When T/D is less than 7.0, the probability of the contact between the metal oxide particles and the hole transport layer increases, thereby increasing the density of current leakage; it is, however, possible to reduce the density of current leakage by increasing the average thickness of the photoelectric conversion layer by 7 times or more as large as the average particle diameter of the metal oxide particles. A ratio T/D of 10 or more significantly decreases the probability of the contact between the metal oxide particles and the hole transport layer and furthermore decreases the density of current leakage.

The average thickness T of the photoelectric conversion layer can be measured in the following manner.

A photoelectric conversion layer is applied onto a substrate and thereafter arbitrarily selected nine sites of the film are wiped with a solvent. The steps at the nine wiped sites are measured with DEKTAK manufactured by Bruker Corporation. The average of the measurements is defined as the average thickness T of the photoelectric conversion layer.

The cross sectional surface is observed with scanning electron microscope (SEM) or TEM to obtain the average thickness of the photoelectric conversion layer.

In the present disclosure, it is possible to sequentially apply the organic material to form a planar junction interface; it is, however, preferable to form a bulk heterojunction formed by three-dimensionally mixing the organic materials to increase the junction interface area.

A material highly soluble in a solvent is dissolved in a solvent to prepare a liquid mixture of each organic material in a form of molecule. After the liquid mixture is applied, the resulting material is dried followed by removing the solvent to form a bulk heterojunction. Optionally, this junction may be heated to optimize the agglomeration state of each semiconductor.

When a material poorly soluble in a solvent is used, a liquid dispersion is prepared in which the organic material is dissolved in a solvent and then the liquid dispersion is applied to form a mixture layer. Optionally, this mixture layer may be heated to optimize the agglomeration state of each semiconductor.

Thin film of the organic material can be formed by methods such as spin coating, blade coating, slid die coating, screen printing, bar coater application, mold application, print transfer method, dip drawing-up method, inkjet method, spraying method, and vacuum deposition method. Of these, a suitable method can be selected to control the thickness and arrangement to suit to attributes of thin film of organic material to be prepared.

In the case of a spin coating, it is preferable to use a solution containing a P-type semiconductor material having a structure represented by the Chemical Formula (1) illustrated above and an N-type material semiconductor material in a range of a content of from 5 to 40 mg/mL.

The content here means the mass of the P-type semiconductor material having a structure represented by the Chemical Formula (1) illustrated above and the N-type semiconductor material to the volume of a solution containing the P-type semiconductor material having a structure represented by the Chemical Formula (1) illustrated above, the N-type semiconductor material, and the solvent. Such a content makes it easy to prepare a uniform photoelectric conversion layer.

Prepared photoelectric conversion layers may be subjected to annealing with a reduced pressure or in an inert gas atmosphere (nitrogen, argon atmosphere) to remove the solvent. The temperature during annealing is preferably from 40 to 300 degrees C and more preferably from 50 to 150 degrees C. The contact area at which laminated layers permeate each other at the interface increases by annealing, which may increase a short-cut current. The annealing may be conducted after forming an electrode.

The solvent to be mixed with the P-type semiconductor material having a structure represented by the Chemical Formula (1) illustrated above and the N-type semiconductor material is not particularly limited and can be suitably selected to suit to a particular application.

Specific examples include, but are not limited to, methanol, ethanol, butanol, toluene, xylene, o-chlorophenol, acetone, ethyl acetate, ethylene glycol, tetrahydrofuran, dichloromethane, chloroform, dichloroethane, chlorobenzene, dichlorobenzene, trichlorobenzene, chloronaphthalene, dimethylformamide, dimethylsulfoxide, N-methylpyrrolidone, and $\gamma$-butyrolactone. These can be used alone or in combination. Of these, chlorobenzene, chloroform, and ortho-dichlorobenzene are preferable.

The solution may optionally contain other components.

The other optional components are not particularly limited and can be selected to suit to a particular application. Additives such as diiodooctane, octane dithiol, and chloronaphthalene are usable.

Hole Transport Layer

It is possible to provide a hole transport layer to enhance collection efficiency of holes.

Specific examples of compounds for use in the hole transport layer include, but are not limited to, electroconductive polymers such as polyethylene dioxy thiophene (PEDOT) : polyethylene sulfonic acid (PSS), hole transport organic compounds such as aromatic amine derivatives, and hole transport inorganic compounds such as molybdenum oxide, tungsten oxide, vanadium oxide, nickel oxide, and copper (I) oxide. These can be used alone or in combination. Of these, molybdenum oxide, tungsten oxide, and vanadium oxide are particularly preferable.

The hole transport layer containing the compound mentioned above can be formed by spin coating, solgel method, or sputtering.

The thickness of the hole transport layer is not particularly limited and can be suitably selected to suit to a particular application. It is preferable to form a thin film covering the entire surface as much as possible and more preferable to have a thickness of from 1 to 50 nm.

Second Electrode

The second electrode is disposed on or overlying the hole transport layer. It is possible to provide a layer such as a second hole transport layer or a layer for collecting charges more effectively.

The second electrode is preferably a metal electrode layer and is preferably made of a metal having a relatively small work function.

The second electrode is made of metal such as gold, silver, aluminum, magnesium, and an alloy of silver-magnesium. Moreover, metal such as gold and aluminum can be laminated to adjust a band structure and color.

The thickness of the second anotherelectrode is not particularly limited and can be selected to suit to a particular application. It is preferably from 20 to 300 nm and more preferably from 50 to 200 nm to achieve good photoelectric conversion.
The second electrode can be formed by wet filming, dry filming such as deposition and sputtering, and printing.

Insulating Layer

The insulating layer prevents the second electrode from directly contacting a sealing member. The insulating layer effectively prevents the electrode from peeling owing to an adhesive sealing member during bending.
The material of the insulating layer is not particularly limited and can be suitably selected to suit to a particular application. Specific examples include, but are not limited to, metal oxides such as $SiO_x$, $SiO_xN_y$, $Al_2O_3$ and polymers such as polyethylene, fluorinated polymers, and poly-p-xylylene. These can be used alone or in combination. Of these, oxides are preferable.
The method of forming an insulating layer is not particularly limited and can be suitably selected to suit to a particular application.
Specific examples include, but are not limited to, vacuum deposition, sputtering, reactive sputtering, molecular beam epitaxy (MBE), plasma chemical vapor deposition (CVD), thermal CVD, gas source CVD, coating, printing, and transfer method.

Sealing Member

The sealing member is used to block gas and moisture from entering into the laminate structure of the photoelectric converter.
The structure member of the sealing member is not particularly limited and can be suitably selected to suit to a particular application. The sealing member is generally formed of film including an adhesive layer, gas barrier layer, and substrate, thereby preventing transmission of moisture or oxygen.
The ability required for a sealing member is in general represented by moisture transmission ratio. Depending on the type of the photoelectric converter or organic thin film solar cell, it is preferably from $1 \times 10^{-2}$ g/m$^2$/day or less. The less, the better.
A preferable example of the member is a substrate having a gas barrier.
If the sealing member is disposed opposite to the light receiving surface, transmission of light does not matter.
There is no specific limit to the adhesive layer of the sealing member as long as it can secure the attributes mentioned above. Known adhesives used to prevent organic electric field luminous element or an organic transistor can be used. Examples include, but are not limited to, pressure sensitive adhesive resins, thermosetting resin compositions, thermoplastic resin compositions, and photocurable resin compositions.
For the adhesive layer, pressure sensitive adhesive resins are preferable because they obviates the need for heating an organic thin film solar cell during the sealing process.
Specific examples include, but are not limited to, ethylene-vinyl acetate copolymer resin compositions, styrene-isobutylene resin compositions, hydrocarbon-based resin compositions, epoxy-based resin compositions, polyester-based resin compositions, acrylic-based resin compositions, urethane resin-based resin compositions, and silicone-based resin compositions. Suitable heat curing, thermoplastic, and photocurable attributes are obtained by changing the main chain, branched chain, chemical decoration at terminals, and molecular weight of a polymer of respective polymers and additives.

Other Layers

There is no specific limitation to the other layers and can be suitably selected to suit to a particular application.
Specific examples include, but are not limited to, an insulating porous layer, anti-degradation layer, and protection layer.
The photoelectric converter of the present disclosure is formed by stacking (tandem) two or more photoelectric conversion layers via one or more intermediate electrode in series or in parallel.
Incident light is wavelength-decomposed by a dichroic mirror or prism and then enters into organic thin film solar cells connected in series or parallel having two or more power generation regions to improve photoelectric conversion efficiency.
FIG. 1 is a diagram illustrating an organic thin film solar cell as an example of the photoelectric converter of the present disclosure. In FIG. 1, reference numerals 1, 2, 3, 4, 5, 6, 7, 8, and 9 respectively represent an organic thin film solar cell, a substrate, a first electrode, an electron transport layer, a photoelectric conversion layer, a hole transport layer, a second electrode, an insulating layer, and a sealing member.

In the organic thin film solar cell 1 illustrated in FIG. 1, the first electrode 3, the electron transport layer 4, the photoelectric conversion layer 5, the hole transport layer 6, the second electrode 7, and the insulating layer 8 are sequentially stacked in this order on the substrate 2. The sealing member 9 covers the laminate formed on the substrate 2 from the insulating 8 while adhering to the insulating layer 8 and the substrate 2.

## Photoelectric Conversion Module

The photoelectric conversion module of the present disclosure is characterized in that the photoelectric conversion module is connected in series or parallel.

The photoelectric conversion module of the present disclosure can be applied to a power source device by combining it with a device such as a circuit board for controlling the generated current.

The deice utilizing a power source device include, but is not limited to, an electronic calculator and a wrist watch. The power source device having the photoelectric converter of the present disclosure can be applied to products such as a cell phone, an electronic organizer, and an electronic paper. A power source device formed of the photoelectric conversion module of the present disclosure can be used as an auxiliary power source or secondary cell to make the continuous operation hours of chargeable or battery-powered electric appliances longer enough to use the appliances even at night. It can be used as a stand alone power source which obviates the need for battery changes and wiring, which can be applied to Internet of Things (IoT) devices and artificial satellites.

## Electronic Device

The first embodiment of the electronic device of the present disclosure includes one or both of the photoelectric converter of the present disclosure and the photoelectric conversion module of the present disclosure, a device that operates on the electricity generated by one or both of the photoelectric converter of the present disclosure and the photoelectric conversion module of the present disclosure, and other optional devices.

The second embodiment of the electronic device of the present disclosure includes one or both of the photoelectric converter of the present disclosure and the photoelectric conversion module of the present disclosure, a rechargeable battery for storing electricity generated by photoelectric conversion by the one or both of the photoelectric converter and the photoelectric converter module, a device that operates on the electricity generated by photoelectric conversion by the one or both of the photoelectric converter and the photoelectric converter module or stored in the rechargeable battery, and other optional devices.

## Power Source Module

The power source module of the present disclosure includes one or both of the photoelectric converter of the present disclosure and the photoelectric conversion module of the present disclosure, a power source integrated circuit (IC), and other optional devices.

An embodiment of electronic device having the photoelectric converter of the present disclosure, the photoelectric conversion module of the present disclosure, and a device that operates on the electricity generated by the photoelectric converter and the photoelectric conversion module is described.

FIG. 3 is a block diagram illustrating a mouse for computer as an example of the electronic device of the present disclosure.

As illustrated in FIG. 3, a photoelectric converter, a photoelectric conversion module, a power control IC, and further a rechargeable device are combined to supply electricity to the power source of the control circuit of the mouse. When the mouse is idle, the rechargeable device is charged. The mouse operates on this charged power. This obviates the need for wiring and battery replacement for the mouse. The mouse can be less-weighed because the mouse does without batteries.

FIG. 4 is a schematic diagram illustrating an example of the mouse illustrated in FIG. 3.

As illustrated in FIG. 4, the photoelectric converter, the power control IC, and the rechargeable device are installed in the inside of the mouse. The upper part of the photoelectric converter is covered with a transparent body to let light into the inside of the photoelectric converter. It is possible to mold the entire body of the mouse with transparent plastic. The photoelectric converter can be arranged in other ways; it can be disposed at the position where the photoelectric converter can receive light even when the mouse is covered with a hand, which may be preferable.

Another embodiment of electronic devices having the photoelectric converter of the present disclosure, the photoelectric conversion module of the present disclosure, and a device that operates on the electricity generated by the photoelectric converter and the photoelectric conversion module is described.

FIG. 5 is a block diagram illustrating a keyboard for computer as an example of the electronic device of the present disclosure.

As illustrated in FIG. 5, a photoelectric converter, a power control IC, and a rechargeable device are combined to supply electricity to the power source of the control circuit of the keyboard. When the keyboard is idle, the rechargeable device is charged. The keyboard operates on this charged power. This obviates the need for wiring and battery replacement for the keyboard. The keyboard can be less-weighed because the keyboard does without batteries.

FIG. 6 is a schematic diagram illustrating an example of the keyboard illustrated in FIG. 5.

As illustrated in FIG. 6, the photoelectric converter, the power control IC, and the rechargeable device are installed in the inside of the keyboard. The upper part of the photoelectric converter is covered with a transparent body to let light into the inside of the photoelectric converter. It is possible to mold the entire body of the keyboard with transparent plastic. The photoelectric converter can be arranged at other positions.

In the case of a small keyboard with a small space for a photoelectric converter, it is possible and effective to embed a small photoelectric converter in a part of keys as illustrated in FIG. 7.

Another embodiment of electronic devices having the photoelectric converter of the present disclosure, the photoelectric conversion module of the present disclosure, and a device that operates on the electricity generated by the photoelectric converter and the photoelectric conversion module is described.

FIG. 8 is a block diagram illustrating a sensor as an example of the electronic device of the present disclosure.

As illustrated in FIG. 8, a photoelectric converter, a power control IC, and a rechargeable device are combined to supply electricity to the power source of the control circuit of the sensor. This configuration can constitute a sensor module without connecting to a power source disposed outside or replacing batteries. The sensor can be applied to sense temperature and humidity, illuminance, human being, $CO_2$, acceleration, ultravioret (UV), noise, geomagnetism, air pressure, and the like. As illustrated in FIG. 8, a sensor module A senses a target at regular intervals and is configured to communicate the read data to a device such as a computer and a smartphone by wireless connection.

The number of sensors is expected to be drastically increasing on the onset of society with the Internet. Replacing batteries one by one for such a great number of sensors takes time and effort and is not realistic. It is difficult to replace batteries of sensors disposed at places such as ceilings and walls. Supplying power with photoelectric converters is significantly advantageous. The photoelectric converter of the present disclosure can output high power at low illumination and the output does not significantly depend on the light entering angle; the freedom of positioning sensors is high.

Another embodiment of electronic devices having the photoelectric converter and the photoelectric conversion module, and a device that operates on the electricity generated by the photoelectric converter and the photoelectric conversion module is described.

FIG. 9 is a block diagram illustrating a turntable as an example of the electronic device of the present disclosure.

As illustrated in FIG. 9, a photoelectric converter, a power control IC, and a rechargeable device are combined to supply electricity to the power source of the control circuit of the turntable. This configuration can constitute a turntable without connecting to a power source disposed outside or replacing batteries.

For example, turntables are placed in a show case displaying merchandise. Wiring of power sources looks bad and is not aesthetic. Merchandise should be removed when replacing batteries, which takes a lot of time and effort. The photoelectric converter of the present disclosure is effective to solve such problems.

## Application Field

The photoelectric converter of the present disclosure and the photoelectric conversion module of the present disclosure are functional as stand alone power supplies; devices are operable with the electricity generated by photoelectric conversion thereof. It is not necessary to connect electronic devices with power sources or replace batteries for them because the photoelectric converter of the present disclosure and the photoelectric conversion module of the present disclosure can generate electricity upon irradiation of light. Electronic devices are operable and wearable even when a power source is unavailable. Electronic devices are operable without battery replacement when battery is not readily replaced. Dry cells make electronic devices heavy or bulky, which makes it difficult to install the electric devices on wall or ceiling or degrades their portability. On the other hand, the photoelectric converter of the present disclosure and the photoelectric conversion module of the present disclosure have a wide latitude of installation and are wearable and portable because they are thin and light-weighed.

The photoelectric converter of the present disclosure and the photoelectric conversion module of the present disclosure can be used as stand alone power sources and can be combined with electronic devices. The photoelectric converter and the photoelectric conversion module can be combined with displays for devices such as desk calculators, wristwatches, mobile phones, electronic organizers, and electronic paper, peripherals to computers such as mice or keyboards, sensors such as temperature and humidity sensors and human sensitive sensors, transmitters such as beacons or global position system (GPS), auxiliary lights, and remote controllers.

The photoelectric converter of the present disclosure and the photoelectric conversion module of the present disclosure can generate electricity at low illuminance.

Low illuminance means 20 to 1,000 lux, which is common in interior environments with lighting. This illuminance

is very weak in comparison with sunlight (approximately, 100,000 lux). These devices are widely applicable because they can generate electricity indoors or even in dim lit places (e.g., shadowed portions). Moreover, the photoelectric converter and the photoelectric conversion module are free of liquid leakage unlike dry cells and safe unlike button cells because they are not swallowed by mistake. These can be used as auxiliary power sources to make the continuous operation hours of rechargeable or dry-cell driven electric appliances longer. When the photoelectric conversion of the photoelectric converter of the present disclosure and the photoelectric conversion module of the present disclosure are combined with a device that is operable on the electricity generated by photoelectric conversion of the photoelectric converter and the photoelectric conversion module, the device becomes highly usable, safe, and convenient, has a wide latitude of installation, and is effective to reduce the burden on the environment.

FIG. 1 is a diagram illustrating a basic configuration of a device including one or both of the photoelectric converter of the present disclosure and the photoelectric conversion module of the present disclosure with an electronic device operable on the electricity generated by photoelectric conversion thereof. The photoelectric converter generates electricity at irradiation of light to take out electricity. The circuit of the device can operate on the electricity, yet the output of the electricity varies depending on the illuminance around the photoelectric converter so that the electronic device illustrated in FIG. 10 may not stably operate. In this case, as illustrated in FIG. 11, a power control IC for the photoelectric converter can be effectively incorporated between the photoelectric converter and the circuit of the device to stably supply the voltage to the circuit.

Without a sufficient illuminance, the photoelectric converter cannot generate target electricity. This is a drawback of the photoelectric converter. If illuminance is insufficient, a rechargeable device such as a capacitor is disposed between the power control IC and the circuit of the device as illustrated in FIG. 12. Owing to this configuration, the rechargeable device is charged with extra electricity from the photoelectric converter. The electricity stored in the rechargeable device is supplied to the circuit of the device when the photoelectric converter is not or insufficiently irradiated with light so that the electric device can be stably operated.

If an electronic device having a combination of one or both of the photoelectric converter of the present disclosure and the photoelectric conversion module of the present disclosure with the circuit of the electronic device is combined with a power control IC or a rechargeable device, the electronic device can operate in environment where a power source is unavailable and stably operates because it obviates the need for battery replacement.

One or both of the photoelectric converter of the present disclosure and the photoelectric conversion module of the present disclosure can be used as a power source module. As illustrated in FIG. 13, when one or both of the photoelectric converter of the present disclosure and the photoelectric conversion module of the present disclosure is connected with a power control IC for the photoelectric converter to constitute a direct current power source module, the power control IC can supply the electricity generated by photoelectric conversion of the photoelectric converter at a certain level of voltage.

Moreover, when a rechargeable device is connected to the power control IC as illustrated in FIG. 14, the rechargeable device is charged with the electricity generated by the photoelectric converter. They constitute a power source module capable of supplying power when the photoelectric converter is not or insufficiently irradiated with light.

The power source module of the present disclosure illustrated in FIGS. 13 and 14 can be used without replacing batteries like a typical primary cell.

Having generally described preferred embodiments of this disclosure, further understanding can be obtained by reference to certain specific examples which are provided herein for the purpose of illustration only and are not intended to be limiting. In the descriptions in the following examples, the numbers represent weight ratios in parts, unless otherwise specified.

## EXAMPLES

Next, embodiments of the present disclosure are described in detail with reference to Examples but are not limited thereto.

### Example 1

#### Preparation of Photoelectric Converter

#### Preparation of Substrate with First Electrode

A polyethylene terephthalate (PET) substrate with a gas barrier film of indium-doped tin oxide (ITO) was procured from GEOMATEC Co., Ltd.

The surface roughness Ra of the ITO was measured with coherence scanning interferometer (VS1550, manufactured by Hitachi, Ltd.). Th resulting Ra was approximately 6 nm.

Formation of Electron Transport Layer

A liquid of zinc oxide nano particles (average particle diameter of 12 nm (D), manufactured by Sigma-Aldrich Corporation) was spin-coated on an ITO filmed gas barrier PET film (15 Ω/□) at 3,000 rotation per minute (rpm) followed by drying at 120 degrees C for 10 minutes to form an electron transport layer having an average thickness of 30 nm.
The number of foreign objects having a diameter of 100 nm or greater present in a region of 100 μm × 100 μm of the surface of the electron transport layer was found to be approximately 10 or less with coherence scanning interferometer (VS1550, manufactured by Hitachi, Ltd.). No further treatment was made.

Formation of Photoelectric Conversion Layer

A liquid application A of photoelectric conversion layer was prepared by dissolving 10 mg of poly(3-hexylthiophene) (P3HT) (number average molecular weight (Mn) of 54,000, manufactured by Sigma-Aldrich Corporation) and 10 mg of PC61BM (manufactured by Sigma-Aldrich Corporation) in 1 mL of chlorobenzene.
The liquid application A of photoelectric conversion layer was spin-coated on the electron transport layer at 1,000 rpm to form a photoelectric conversion layer having an average thickness of 200 nm (T).
Using a coherence scanning interferometer (VS1550, manufactured by Hitachi, Ltd.), the difference between the average thickness and the minimum thickness of the photoelectric conversion layer in the effective power generation region was found to be approximately 60 nm.

Formation of Hole Transport Layer and Formation of Second Electrode

A hole transport layer of molybdenum oxide (manufactured by KOJUNDO CHEMICAL LABORATORY CO., LTD.) having a thickness of 20 nm and a second electrode made of gold having a thickness of 70 nm were sequentially vacuum-deposited on the photoelectric conversion layer.
The photoreceptor of Example 1 was thus manufactured.

Example 2

Preparation of Photoelectric Converter

A photoelectric converter was prepared in the same manner as in Example 1 except that the liquid application A of the photoelectric conversion layer was replaced with the following liquid application B of the photoelectric conversion layer.
Using a coherence scanning interferometer (VS1550, manufactured by Hitachi, Ltd.), the difference between the average thickness and the minimum thickness of the photoelectric conversion layer in the effective power generation region was found to be approximately 60 nm.

Preparation of Liquid Application B of Photoelectric conversion Layer

A total of 10 mg of PTB-7 (number average molecular weight (Mn) of 78,000, manufactured by Ossila Limited) and 15 mg of PC61BM (manufactured by Sigma-Aldrich Corporation) were dissolved in 1 mL of chlorobenzene containing 1,8-diiodo octane at 3.5 percent by volume to prepare a liquid application B of photoelectric conversion layer.

Example 3

Preparation of Photoelectric Converter

A photoelectric converter was prepared in the same manner as in Example 1 except that the liquid application A of the photoelectric conversion layer was replaced with a liquid application C of the photoelectric conversion layer followed by forming an electron transport layer and a photoelectric conversion layer in the following manner.

Formation of Electron Transport Layer

A liquid of zinc oxide nano particle (average particle diameter of 12 nm (D), manufactured by Sigma-Aldrich Corporation) was spin-coated on an ITO filmed gas barrier PET film (15 Ω/□) at 1,000 rpm followed by drying at 120 degrees C for 10 minutes to form an electron transport layer having an average thickness of 40 nm.
The number of foreign objects having a diameter of 100 nm or greater present in a region of 100 μm × 100

µm of the surface of the electron transport layer was found to be approximately 10 or less with coherence scanning interferometer (VS1550, manufactured by Hitachi, Ltd.). No further treatment was made.

Formation of Photoelectric Conversion Layer

The liquid application C of photoelectric conversion layer was prepared by dissolving 14 mg of the following compound 1 illustrated below (number average molecular weight (Mn) of 1,554) and 9 mg of the following compound 2 illustrated below in 1 mL of chloroform.

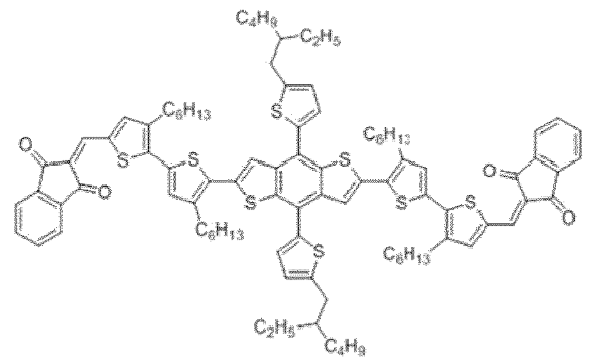

Illustrated Compound 1

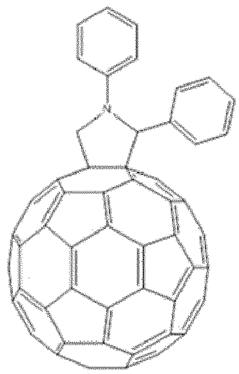

Illustrated Compound 2

The liquid application C of photoelectric conversion layer was spin-coated on the electron transport layer at 600 rpm to form a photoelectric conversion layer having an average thickness of 150 nm (T).

Using a coherence scanning interferometer (VS1550, manufactured by Hitachi, Ltd.), the difference between the average thickness and the minimum thickness of the photoelectric conversion layer in the effective power generation region was found to be approximately 40 nm.

Example 4

Preparation of Photoelectric Converter

A photoelectric converter was prepared in the same manner as in Example 3 except that an electron transport layer, a photoelectric transduction layer, a hole transport layer, a second electrode, and an insulating layer were formed in the following manner followed by sealing.

Formation of Electron Transport Layer

A liquid of zinc oxide nano particles (average particle diameter of 12 nm (D), manufactured by Sigma-Aldrich Corporation) was spin-coated on an ITO filmed gas barrier PET film (15 Ω/□) at 1,000 rpm followed by drying at 120 degrees C for 10 minutes to form an electron transport layer having an average thickness of 40 nm.

An ethanol solution of dimethylamino benzoate was prepared at a content of 1 mg/mL on the electron transport layer to form a film on the zinc oxide nano particles at 1,500 rpm. The number of foreign objects having a diameter of

100 nm or greater present in a region of 100 μm × 100 μm of the surface of the electron transport layer was found to be approximately 10 or less with coherence scanning interferometer (VS1550, manufactured by Hitachi, Ltd.). No further treatment was made.

Formation of Photoelectric Conversion Layer

The liquid application C of photoelectric conversion layer was spin-coated on the electron transport layer at 600 rpm to form a photoelectric conversion layer having an average thickness of 150 nm (T).

Using a coherence scanning interferometer (VS1550, manufactured by Hitachi, Ltd.), the difference between the average thickness and the minimum thickness of the photoelectric conversion layer in the effective power generation region was found to be approximately 30 nm.

Formation of Hole Transport Layer and Formation of Second Electrode

A hole transport layer of molybdenum oxide (manufactured by KOJUNDO CHEMICAL LABORATORY CO., LTD.) having a thickness of 20 nm and a second electrode made of gold having a thickness of 70 nm were sequentially vacuum deposited on the photoelectric conversion layer.

Formation of Insulating Layer

A liquid dispersion of aluminium oxide nano particles (manufactured by Sigma-Aldrich Corporation) was spin-coated on the prepared photoelectric converter at 1,500 rpm so that a 300 nm insulating layer was formed.

Sealing

A sealing member on which an adhesive layer was formed on PET covered with aluminium was applied to the insulating layer of the photoelectric converter to cover the photoelectric converter using a roll laminator. The PET substrate in the photoelectric converter and the sealing member were attached to each other followed by sealing.

Example 5

Preparation of Photoelectric Converter

A photoelectric converter was prepared in the same manner as in Example 4 except that the liquid application C of the photoelectric conversion layer was replaced with the following liquid application D of the photoelectric conversion layer.

The difference between the average thickness and the minimum thickness of the photoelectric conversion layer in the effective power generation region was found to be approximately 60 nm in Example 5.

Preparation of Liquid Application D of Photoelectric Conversion Layer

A total of 15 mg of the compound 1 illustrated above and 10 mg of PC61BM (E100H, manufactured by Frontier Carbon Corporation) were dissolved in 1 mL of chloroform to prepare the liquid dispersion D of photoelectric conversion layer.

Example 6

Preparation of Photoelectric Converter

A photoelectric converter was prepared in the same manner as in Example 4 except that the liquid application C of the photoelectric conversion layer was replaced with the following liquid application E of the photoelectric conversion layer.

The difference between the average thickness and the minimum thickness of the photoelectric conversion layer in the effective power generation region was found to be approximately 40 nm in Example 6.

Preparation of Liquid Application E of Photoelectric Conversion Layer

The liquid application E of photoelectric conversion layer was prepared by dissolving 15 mg of the compound

3 illustrated below (number average molecular weight (Mn) of 1,463) and 10 mg of the compound 2 illustrated above in 1 mL of chloroform.

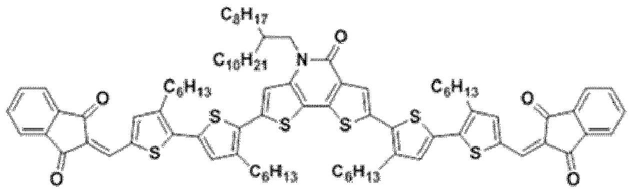

Illustrated Compound 3

Example 7

Preparation of Photoelectric Converter

A photoelectric converter was prepared in the same manner as in Example 4 except that the average thickness of the photoelectric conversion layer was changed to 100 nm (T).

The difference between the average thickness and the minimum thickness of the photoelectric conversion layer in the effective power generation region was found to be approximately 40 nm in Example 7.

Example 8

Preparation of Photoelectric Converter

A photoelectric converter was prepared in the same manner as in Example 4 except that the liquid dispersion of zinc oxide nano particles for use in forming the electron transport layer was changed to a liquid dispersion of zinc oxide nano particles (average particle diameter of 30 nm (D), manufactured by TAYCA CORPORATION) to form a photoelectric conversion layer having an average thickness of 230 nm (T).

The number of foreign objects having a diameter of 100 nm or greater present in a region of 100 μm × 100 μm of the surface of the electron transport layer was found to be approximately 10 or less in Example 8. No further treatment was made. The difference between the average thickness and the minimum thickness of the photoelectric conversion layer in the effective power generation region was found to be approximately 30 nm.

Example 9

Preparation of Photoelectric Converter

A photoelectric converter was prepared in the same manner as in Example 4 except that the average thickness (T) of the photoelectric conversion layer was changed to 310 nm.

The difference between the average thickness and the minimum thickness of the photoelectric conversion layer in the effective power generation region was found to be approximately 60 nm in Example 9.

Example 10

Preparation of Photoelectric Converter

A photoelectric converter was prepared in the same manner as in Example 4 except that the liquid application C of the photoelectric conversion layer was replaced with the following liquid application F of the photoelectric conversion layer.

The difference between the average thickness and the minimum thickness of the photoelectric conversion layer in the effective power generation region was found to be approximately 40 nm in Example 10.

Preparation of Liquid Application F of Photoelectric Conversion Layer

The liquid application F of photoelectric conversion layer was prepared by dissolving 12.5 mg of the compound 4 illustrated below (number average molecular weight (Mn) of 2,029) and 12.5 mg of the compound 2 illustrated above

in 1 mL of chloroform.

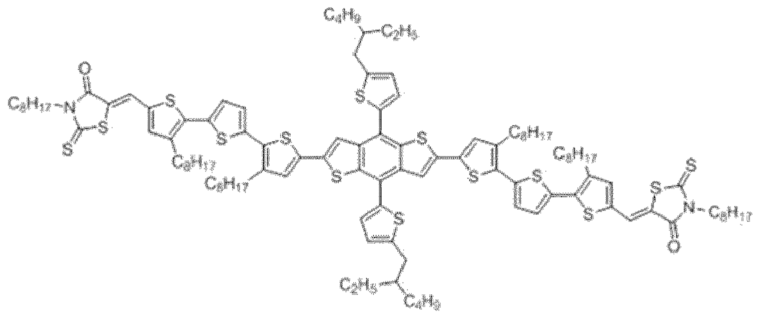

Illustrated Compound 4

Example 11

Preparation of Photoelectric Converter

A photoelectric converter was prepared in the same manner as in Example 4 except that the substrate with first electrode was replaced with the following substrate with first electrode.

Substrate with First Electrode

A glass substrate (10 Ω/□) on which ITO was formed was procured from Nippon Electric Glass Co., Ltd.
Using a coherence scanning interferometer (VS1550, manufactured by Hitachi, Ltd.), the ITO was found to have a surface toughness Ra of approximately 5 nm.

Example 12

Preparation of Photoelectric Converter

A photoelectric converter was prepared in the same manner as in Example 4 except that the electron transport layer was changed to the following and the average thickness of the photoelectric conversion layer was changed to 90 nm (T).
The difference between the average thickness and the minimum thickness of the photoelectric conversion layer in the effective power generation region was found to be approximately 20 nm in Example 12.

Formation of Electron Transport Layer

Aluminum-doped zinc oxide nano particle (average particle diameter of 12 nm (D), manufactured by Sigma-Aldrich Corporation) was spin-coated on an ITO filmed gas barrier PET film (15 Ω/□) at 1,000 rpm followed by drying at 120 degrees C for 10 minutes to form an electron transport layer having an average thickness of 40 nm.
The number of foreign objects having a diameter of 100 nm or greater present in a region of 100 μm × 100 μm of the surface of the electron transport layer was found to be approximately 10 or less. No further treatment was made.

Example 13

Preparation of Photoelectric Converter

A photoelectric converter was prepared in the same manner as in Example 4 except that the electron transport layer was changed to the following and the average thickness of the photoelectric conversion layer was changed to 70 nm (T).
The difference between the average thickness and the minimum thickness of the photoelectric conversion layer in the effective power generation region was found to be approximately 20 nm in Example 13.

Formation of Electron Transport Layer

Tin oxide nano particles (average particle diameter of 7 nm (D), manufactured by Sigma-Aldrich Corporation) were spin-coated on an ITO filmed gas barrier PET film (15 Ω/□) at 1,000 rpm followed by drying at 80 degrees C for 10 minutes to form an electron transport layer having an average thickness of 20 nm.

The number of foreign objects having a diameter of 100 nm or greater present in a region of 100 μm × 100 μm of the surface of the electron transport layer was found to be approximately 10 or less. No further treatment was made.

Example 14

A photoelectric converter was prepared in the same manner as in Example 11 except that the electron transport layer was changed to the following.

Formation of Electron Transport Layer

An ethanol liquid dispersion of zinc titanium nano particle paste (average particle diameter of 20 nm, manufactured by JGC Catalysts and Chemicals Ltd.) was spin-coated on an ITO filmed glass substrate (10 Ω/□, manufactured by Nippon Electric Glass Co., Ltd.) at 1,000 rpm followed by heating at 450 degrees C for 30 minutes to form an electron transport layer having an average thickness of 100 nm.

The number of foreign objects having a diameter of 100 nm or greater present in a region of 100 μm × 100 μm of the surface of the electron transport layer was found to be approximately 10 or less. No further treatment was made.

The difference between the average thickness and the minimum thickness of the photoelectric conversion layer in the effective power generation region was found to be approximately 30 nm in Example 14.

Example 15

Preparation of Photoelectric Converter

A photoelectric converter was prepared in the same manner as in Example 4 except that the hole transport layer was changed to the following.

Formation of Hole Transport Layer

Tungsten oxide (manufactured by KOJUNDO CHEMICAL LABORATORY CO., LTD.) was deposited onto the photoelectric conversion layer to form a hole transport layer having an average thickness of 20 nm.

Example 16

Preparation of Photoelectric Converter

A photoelectric converter was prepared in the same manner as in Example 4 except that the hole transport layer was changed to the following.

Formation of Hole Transport Layer

Vanadium oxide (manufactured by KOJUNDO CHEMICAL LABORATORY CO., LTD.) was deposited onto the photoelectric conversion layer to form a hole transport layer having an average thickness of 20 nm.

Example 17

Preparation of Photoelectric Converter

A photoelectric converter was prepared in the same manner as in Example 4 except that the average thickness of the photoelectric conversion layer was changed to 470 nm (T).

The difference between the average thickness and the minimum thickness of the photoelectric conversion layer in the effective power generation region was found to be approximately 50 nm in Example 17.

Example 18

Preparation of Photoelectric Converter

A photoelectric converter was prepared in the same manner as in Example 4 except that the average thickness of the photoelectric conversion layer was changed to 550 nm (T).

The difference between the average thickness and the minimum thickness of the photoelectric conversion layer in the effective power generation region was found to be approximately 50 nm in Example 18.

Comparative Example 1

Preparation of Photoelectric Converter

A photoelectric converter was prepared in the same manner as in Example 4 except that the liquid dispersion of zinc oxide nano particles for use in forming the electron transport layer was changed to a liquid dispersion of zinc oxide nano particles (average particle diameter of 30 nm (D), manufactured by TAYCA CORPORATION).

The number of foreign objects having a diameter of 100 nm or greater present in a region of 100 μm × 100 μm of the surface of the electron transport layer was found to be approximately 10 or less in Comparative Example 1. No further treatment was made.

Comparative Example 2

Preparation of Photoelectric Converter

A photoelectric converter was prepared in the same manner as in Example 4 except that the average thickness of the photoelectric conversion layer was changed to 70 nm (T).

The difference between the average thickness and the minimum thickness of the photoelectric conversion layer in the effective power generation region was found to be approximately 20 nm in Comparative Example 2.

Comparative Example 3

Preparation of Photoelectric Converter

A photoelectric converter (Organic solar cell Module #3) was procured from InifinityPV ApS as the photoelectric converter of Comparative Example 3.

The details of the material and the layer structure of the photoelectric converter of Comparative Example 3 are unavailable. The photoelectric converter of Comparative Example 3 had an extremely high density of current leakage. The density could not be precisely measured; it is, however, inferred that the ratio of current leakage was 0.99 or greater at an illuminance of 200 lux.

Properties of the prepare photoelectric converters were evaluated in the following manner. The results are shown in Table 1.

Measurement of HOMO Level

The highest occupied molecular orbital (HOMO) of the photoelectric conversion layer of the obtained photoelectric converter was measured using a photoemission yield spectroscopy in air (AC-2, manufactured by RIKEN KEIKI Co., Ltd.).

Evaluation on Attributes of Photoelectric Converter

The current-voltage of each of the obtained photoelectric converters were measured at an illuminance of white light emitting diode (LED) illumination of 100, 200, 2,000, 5,000, 10,000, and 18,000 lux.

The white LED was a light-bulb form LED lamp (LDA11N G/100 W, manufactured by TOSHIBA Lighting & Technology Corporation). The current-voltage was measured using an evaluation device (source meter, KEYSIGHT B2902A).

Ratio $P_L$ of Current Leakage

The illuminance of the white LED illumination was measured with an illuminometer (510 LUX METER, manufactured by Yokogawa Electric Corporation). The ratio $P_L$ of current leakage was obtained by the device evaluation and the current leakage ratio $P_L$ mentioned above using the density of short circuit current obtained at each illuminance and the values of open-circuit voltage.

Ratio $P_\eta$ of Energy Conversion Efficiency

The ratio $P_\eta$ of energy conversion efficiency was calculated between at 100 lux, low illuminance lower than 200 lux and a high illuminance of 20,000 lux according to the following equation (6):

$$\text{Ratio } P_\eta = \eta_{100}/\eta_{20000} \quad (6)$$

In the equation (6), $\eta_{100}$ and $\eta_{20000}$ respectively represent energy conversion efficiency at an illuminance of 100 lux and 20,000 lux of the light source.

Ratio (T/D)

The ratio of the average particle diameter of the metal oxide particles and the average thickness of the photoelectric conversion layer were obtained for each photoelectric converter. The average particle diameter (D) of the metal oxide particle was measured as described above. The average thickness of the photoelectric conversion layer was measured according to the method described above.

Table 1

| | HOMO level of photoelectric conversion layer | Ratio $P_\eta$ of energy conversion efficiency | Ratio $P_L$ of current leakage | Average particle diameter (D) of metal oxide particle | Average thickness (T) (nm) of photoelectric conversion layer | Ratio (T/D) |
|---|---|---|---|---|---|---|
| Example 1 | 4.9 eV | 0.81 | 0.66 | 12 | 200 | 16.7 |
| Example 2 | 5.1 eV | 0.82 | 0.65 | 12 | 200 | 16.7 |
| Example 3 | 5.2 eV | 0.80 | 0.68 | 12 | 150 | 12.5 |
| Example 4 | 5.2 eV | 0.86 | 0.62 | 12 | 150 | 12.5 |
| Example 5 | 5.2 eV | 0.76 | 0.71 | 12 | 150 | 12.5 |
| Example 6 | 5.3 eV | 0.80 | 0.67 | 12 | 150 | 12.5 |
| Example 7 | 5.2 eV | 0.75 | 0.81 | 12 | 100 | 8.3 |
| Example 8 | 5.2 eV | 0.74 | 0.83 | 30 | 230 | 7.6 |
| Example 9 | 5.2 eV | 0.91 | 0.59 | 12 | 310 | 25.8 |
| Example 10 | 5.3 eV | 0.80 | 0.68 | 12 | 150 | 12.5 |
| Example 11 | 5.2 eV | 0.86 | 0.64 | 12 | 150 | 12.5 |
| Example 12 | 5.2 eV | 0.72 | 0.93 | 12 | 90 | 7.5 |
| Example 13 | 5.2 eV | 0.70 | 0.90 | 7 | 70 | 10.0 |
| Example 14 | 5.2 eV | 0.86 | 0.63 | 20 | 150 | 7.5 |
| Example 15 | 5.2 eV | 0.88 | 0.65 | 12 | 150 | 12.5 |
| Example 16 | 5.2 eV | 0.85 | 0.64 | 12 | 150 | 12.5 |
| Example 17 | 5.2 eV | 0.90 | 0.60 | 12 | 470 | 39.2 |
| Example 18 | 5.2 eV | 0.73 | 0.85 | 12 | 550 | 45.8 |

(continued)

| | HOMO level of photoelectric conversion layer | Ratio $P_\eta$ of energy conversion efficiency | Ratio $P_L$ of current leakage | Average particle diameter (D) of metal oxide particle | Average thickness (T) (nm) of photoelectric conversion layer | Ratio (T/D) |
|---|---|---|---|---|---|---|
| Comparative Example 1 | 5.2 eV | 0.48 | 0.97 | 30 | 150 | 5.0 |
| Comparative Example 2 | 5.2 eV | 0.47 | 0.98 | 12 | 70 | 5.8 |
| Comparative Example 3 | - | 0.12 | > 0.99 | - | - | - |

As seen in the results shown in Table 1, every photoelectric converter of Examples 1 to 18 had a ratio $P_L$ of current leakage of 0.95 eV or less. The ratio of the energy conversion efficiency at a low illumination environment against the energy conversion efficiency in a high illumination environment was 70 percent or more; the photoelectric conversion efficiency at a low illumination environment does not significantly deteriorate in comparison with the photoelectric conversion efficiency in a high illumination environment.

Conversely, the ratio $P_L$ of current leakage of the photoelectric converters of Comparative Examples 1 to 3 surpasses 0.95; the energy conversion efficiency in a low illumination environment is down more than 50 percent in comparison with the photoelectric conversion efficiency in a high illumination environment.

Aspects of the present disclosure are, for example, as follows.

1. A photoelectric converter (1) includes a substrate (2), a first electrode (3) on the substrate (2), an electron transport layer (4) overlying the first electrode (3), a photoelectric conversion layer (5) overlying the first electrode (3), the photoelectric conversion layer (5) containing at least two types of organic materials, a hole transport layer (6) overlying the photoelectric conversion layer (5), and a second electrode (7) overlying the hole transport layer (6), wherein the photoelectric converter (1) has a ratio $P_L$ of current leakage of 0.95 or less at an illuminance of 200 lux, where the ratio $P_L$ is calculated from the following equation (1):

$$P_L = L/J_{ph} \quad \text{Equation (1).}$$

In the equation (1), L represents a density ($\mu A/cm^2$) of current leakage at an illuminance of 200 lux and $J_{ph}$ represents a density ($\mu A/cm^2$) of photocurrent at an illuminance of 200 lux.

2. The photoelectric converter (1) according to 1 mentioned above, wherein the electron transport layer (4) contains metal oxide particles, wherein the following relationship is satisfied, $7.0 \leq T/D$, where T represents an average thickness of the photoelectric conversion layer (5) and D represents an average particle diameter of the metal oxide particles.

3. The photoelectric converter (1) according to 1 or 2 mentioned above, further comprising an insulating layer (8), wherein the first electrode (3) comprises a transparent electroconductive film.

4. The photoelectric converter (1) according to 2 or 3 mentioned above, wherein the metal oxide particles contain particles of zinc oxide, titanium oxide, or tin oxide.

5. The photoelectric converter (1) according to any one of 1 to 4 mentioned above, wherein the hole transport layer (6) comprises metal oxides selected from the group consisting of molybdenum oxide, tungsten oxide, and vanadium oxide.

6. The photoelectric converter (1) according to any one of 1 to 5 mentioned above, wherein one of the at least two types of organic materials comprises an electron donor having a highest occupied molecular orbital (HOMO) level of from 5.1 to 5.5 eV and a number average molecular weight (Mn) of 10,000 or less.

7. The photoelectric converter (1) according to any one of 1 to 6 mentioned above, wherein the one of the at least two types of organic materials is represented by a compound represented by the following Chemical Formula (1)

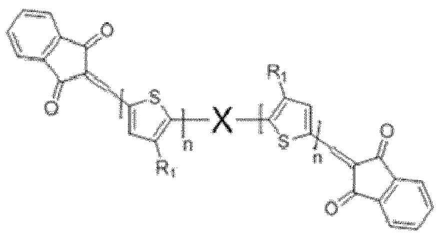

(1)

where $R_1$ represents an alkyl group having 2 to 8 carbon atoms, A symbol "n" represents an integer of from 1 to 2. X represents a group represented by the following Chemical Formula (2) or the following Chemical Formula (3)

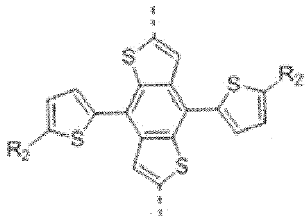

(2)

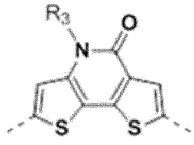

(3)

In the Chemical Formulae (2) and (3), $R_2$ and $R_3$ each, independently represent linear or branched alkyl groups.

8. The photoelectric converter (1) according to 6 or 7 mentioned above, wherein the at least two types of organic materials excluding the one of the at least two types of organic materials comprise fullerene derivatives.

9. The photoelectric converter (1) according to any one of 1 to 8 mentioned above, wherein the electron transport layer (4) comprises a first electron transport layer containing metal oxide particles and a second electron transport layer between the first electron transport layer and the photoelectric conversion layer (5), wherein the second electron transport layer contains an amine compound represented by the following Chemical Formula (4)

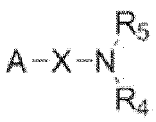

(4)

where $R_4$ and $R_5$ each, independently represent substituted or non-substituted alkyl groups having 1 to 4 carbon atoms, X represents a divalent aromatic group having 6 to 14 carbon atoms or an alkyl group having 1 to 4 carbon atoms, $R_4$ and $R_5$ may share a linkage to form a ring, and A represents one of -COOH, -P(=O)($OH_2$), and -Si$(OH)_3$.

10. A photoelectric converter module includes the photoelectric converters (1) of any one of 1 to 9 mentioned above which are connected in series or parallel.

11. An electronic device includes one or both of the photoelectric converter (1) of any one of claims 1 to 9, the photoelectric converter module of 10 mentioned above, and a device configured to operate on electricity generated by photoelectric conversion by the one or both of the photoelectric converter and the photoelectric converter module.

12. An electronic device includes one or both of the photoelectric converter (1) of any one of claims 1 to 9, the photoelectric converter module of 10 mentioned above, and a rechargeable battery configured to store electricity generated by photoelectric conversion by the one or both of the photoelectric converter (1) and the photoelectric converter module, and a device configured to operate on the electricity generated by photoelectric conversion by the one or both of the photoelectric converter (1) and the photoelectric converter module or stored in the rechargeable

battery.
13. A power source module includes one or both of the photoelectric converter (1) of any one of 1 to 9 mentioned above and the photoelectric converter module of 10 mentioned above; and a power control IC.

Numerous additional modifications and variations are possible in light of the above teachings. It is therefore to be understood that, within the scope of the above teachings, the present disclosure may be practiced otherwise than as specifically described herein. With some embodiments having thus been described, it will be obvious that the same may be varied in many ways. Such variations are not to be regarded as a departure from the scope of the present disclosure and appended claims, and all such modifications are intended to be included within the scope of the present disclosure and appended claims.

## Claims

1. A photoelectric converter (1) comprising:

   a substrate (2);
   a first electrode (3) on the substrate (2);
   an electron transport layer (4) overlying the first electrode (3);
   a photoelectric conversion layer (5) overlying the electron transport layer (4), the photoelectric conversion layer (5) containing at least two types of organic materials;
   a hole transport layer (6) overlying the photoelectric conversion layer (5); and
   a second electrode (7) overlying the hole transport layer (6),
   wherein the photoelectric converter (1) has a ratio $P_L$ of current leakage of 0.95 or less at an illuminance of 200 lux, where the ratio $P_L$ is calculated from the following equation (1):

$$P_L = L/J_{ph} \quad \text{Equation (1),}$$

   where L represents a density ($\mu A/cm^2$) of current leakage at an illuminance of 200 lux and $J_{ph}$ represents a density ($\mu A/cm^2$) of photocurrent density at an illuminance of 200 lux.

2. The photoelectric converter (1) according to claim 1,
   wherein the electron transport layer (4) comprises metal oxide particles, wherein the following relationship is satisfied, $7. \leq T/D$, where T represents an average thickness of the photoelectric conversion layer (5) and D represents an average particle diameter of the metal oxide particles.

3. The photoelectric converter (1) according to claim 1 or 2, further comprising an insulating layer (8), wherein the first electrode (3) comprises a transparent electroconductive film.

4. The photoelectric converter (1) according to claim 2 or 3, wherein the metal oxide particles comprise particles of zinc oxide, titanium oxide, or tin oxide.

5. The photoelectric converter (1) according to any one of claims 1 to 4, wherein the hole transport layer (6) comprises molybdenum oxide, tungsten oxide, or vanadium oxide.

6. The photoelectric converter (1) according to any one of claims 1 to 5, wherein one of the at least two types of organic materials comprises an electron donor having a highest occupied molecular orbital (HOMO) level of from 5.1 to 5.5 eV and a number average molecular weight (Mn) of 10,000 or less.

7. The photoelectric converter (1) according to any one of claims 1 to 6, wherein one of the at least two types of organic materials comprises a compound represented by the following Chemical Formula (1):

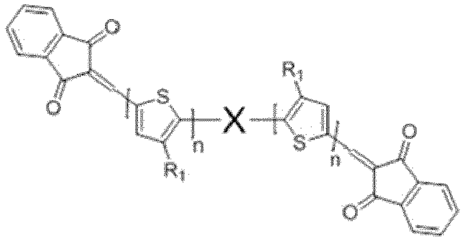

Chemical Formula (1)

where $R_1$ represents an alkyl group having 2 to 8 carbon atoms, n represents an integer of from 1 to 2, and X represents a group represented by the following Chemical Formula (2) or the following Chemical Formula (3):

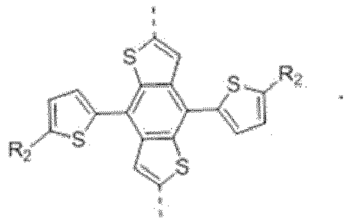

Chemical Formula (2)

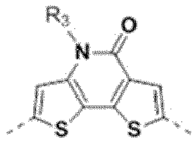

Chemical Formula (3)

where $R_2$ and $R_3$ each, independently represent linear or branched alkyl groups.

**8.** The photoelectric converter (1) according to claim 6 or 7, wherein the at least two types of organic materials excluding the one of the at least two types of organic materials comprise fullerene derivatives.

**9.** The photoelectric converter (1) according to any one of claims 1 to 8,
wherein the electron transport layer (4) comprises a first electron transport layer containing metal oxide particles and a second electron transport layer between the first electron transport layer and the photoelectric conversion layer (5),
wherein the second electron transport layer comprises an amine compound represented by the following Chemical Formula (4)

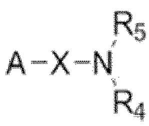

Chemical Formula (4)

where $R_4$ and $R_5$ each, independently represent substituted or non-substituted alkyl groups having 1 to 4 carbon atoms, X represents a divalent aromatic group having 6 to 14 carbon atoms or an alkyl group having 1 to 4 carbon atoms, $R_4$ and $R_5$ may share a linkage to form a ring, and A represents one of -COOH, $-P(=O)(OH_2)$, and $-Si(OH)_3$.

**10.** A photoelectric converter module comprising:
the photoelectric converters (1) of any one of claims 1 to 9 which are connected in series or parallel.

**11.** An electronic device comprising:

one or both of the photoelectric converter (1) of any one of claims 1 to 9 and the photoelectric converter module of claim 10; and
a device configured to operate on electricity generated by photoelectric conversion by the one or both of the photoelectric converter (1) and the photoelectric converter module.

**12.** An electronic device comprising:

one or both of the photoelectric converter (1) of any one of claims 1 to 9 and the photoelectric converter module of claim 10; and
a rechargeable battery configured to store electricity generated by photoelectric conversion by the one or both of the photoelectric converter (1) and the photoelectric converter module; and
a device configured to operate on the electricity generated by photoelectric conversion by the one or both of the photoelectric converter (1) and the photoelectric converter module or stored in the rechargeable battery.

**13.** A power source module comprising:

one or both of the photoelectric converter (1) of any one of claims 1 to 9 and the photoelectric converter module of claim 10; and
a power control IC.

FIG. 1

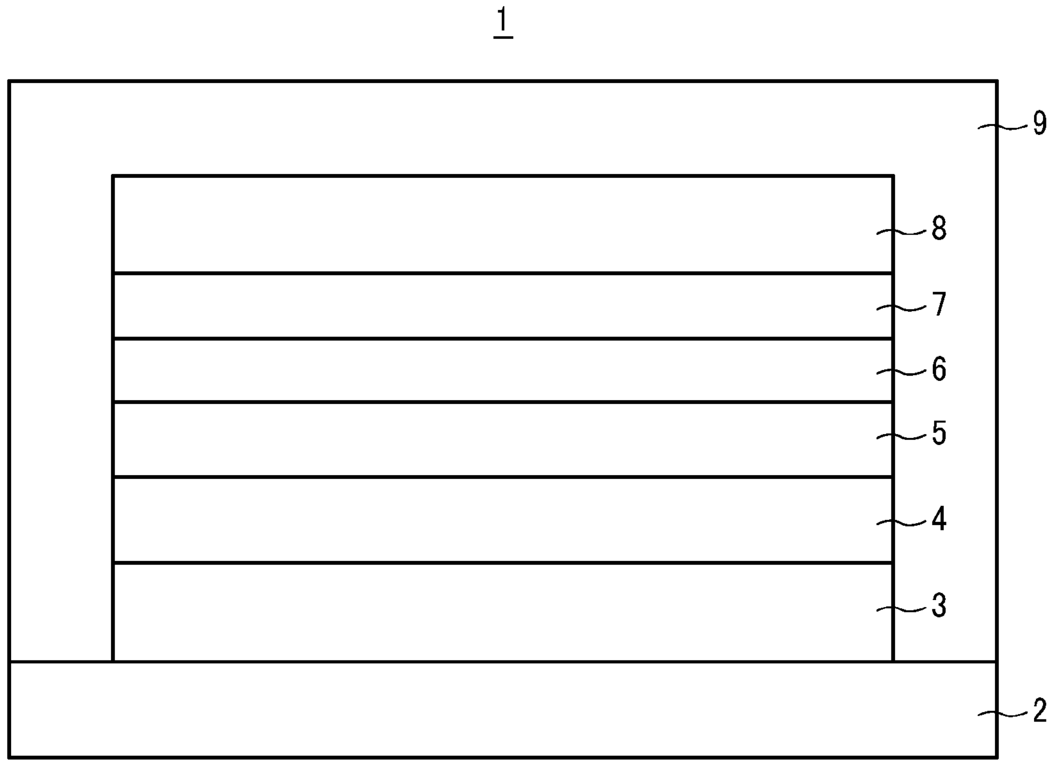
1
9
8
7
6
5
4
3
2

FIG. 2

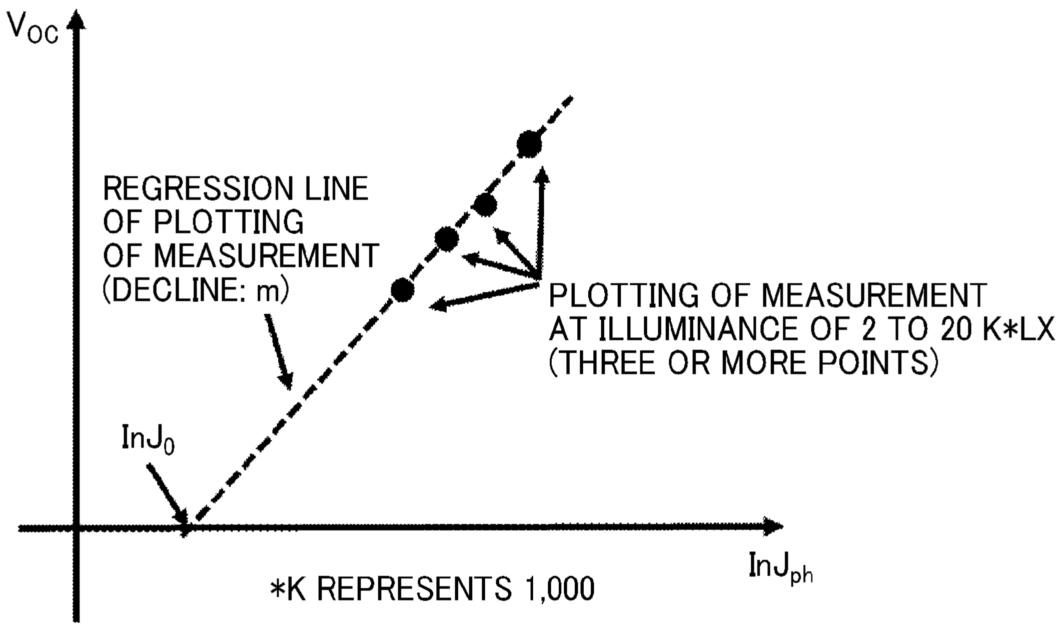
$V_{OC}$
REGRESSION LINE
OF PLOTTING
OF MEASUREMENT
(DECLINE: m)
PLOTTING OF MEASUREMENT
AT ILLUMINANCE OF 2 TO 20 K*LX
(THREE OR MORE POINTS)
$\ln J_0$
$\ln J_{ph}$
*K REPRESENTS 1,000

FIG. 3

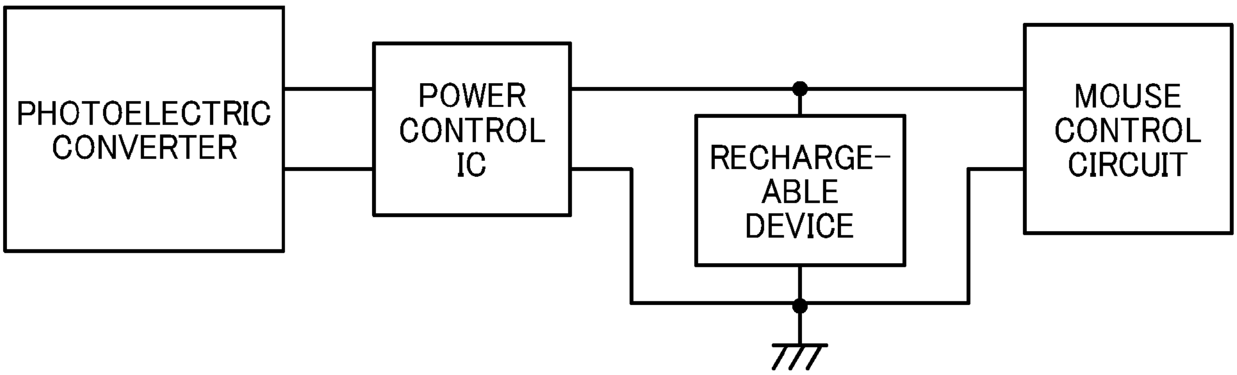
PHOTOELECTRIC CONVERTER
POWER CONTROL IC
RECHARGE-ABLE DEVICE
MOUSE CONTROL CIRCUIT

FIG. 4

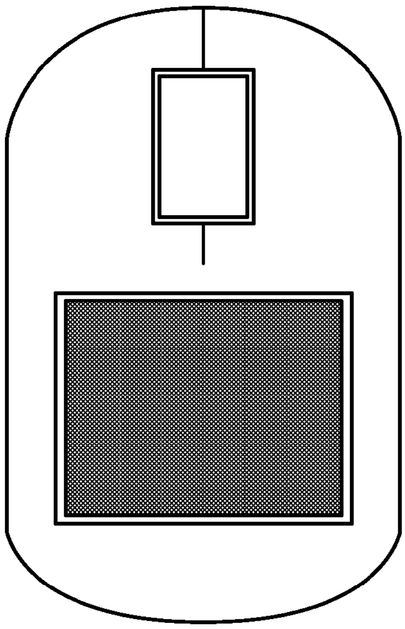

FIG. 5

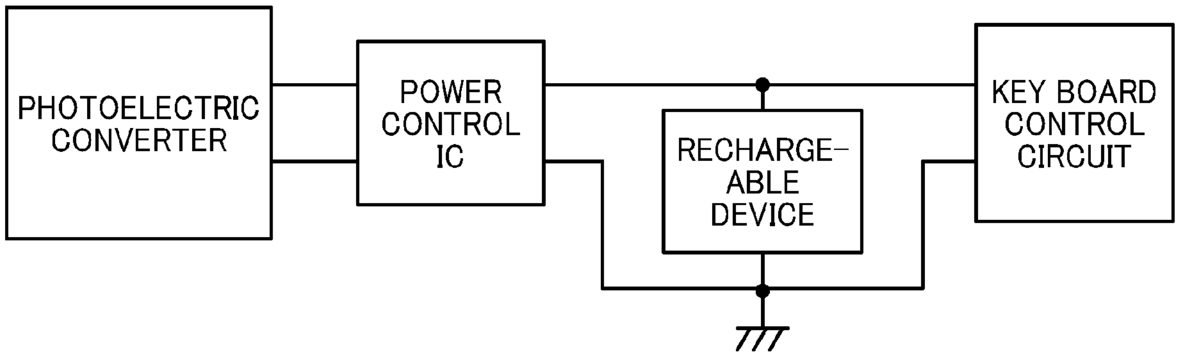


FIG. 6

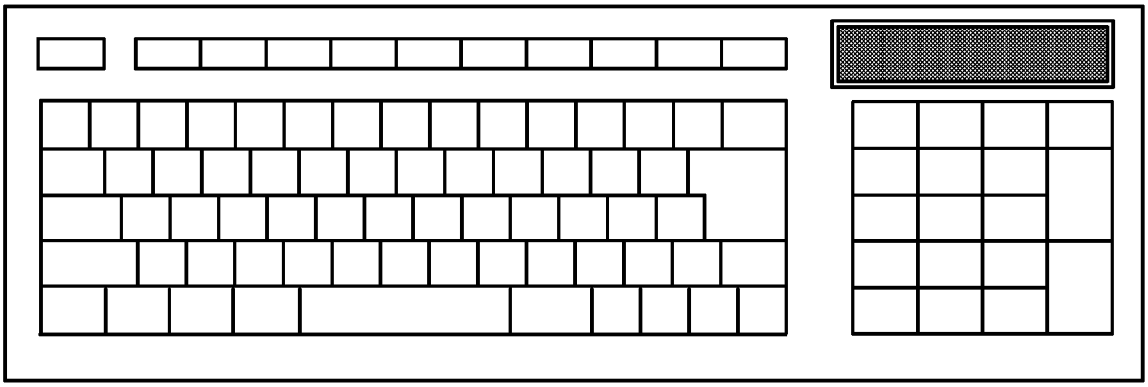

FIG. 7

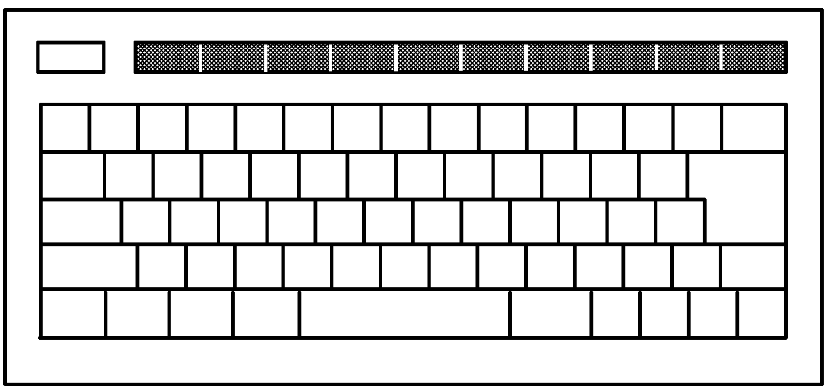

FIG. 8

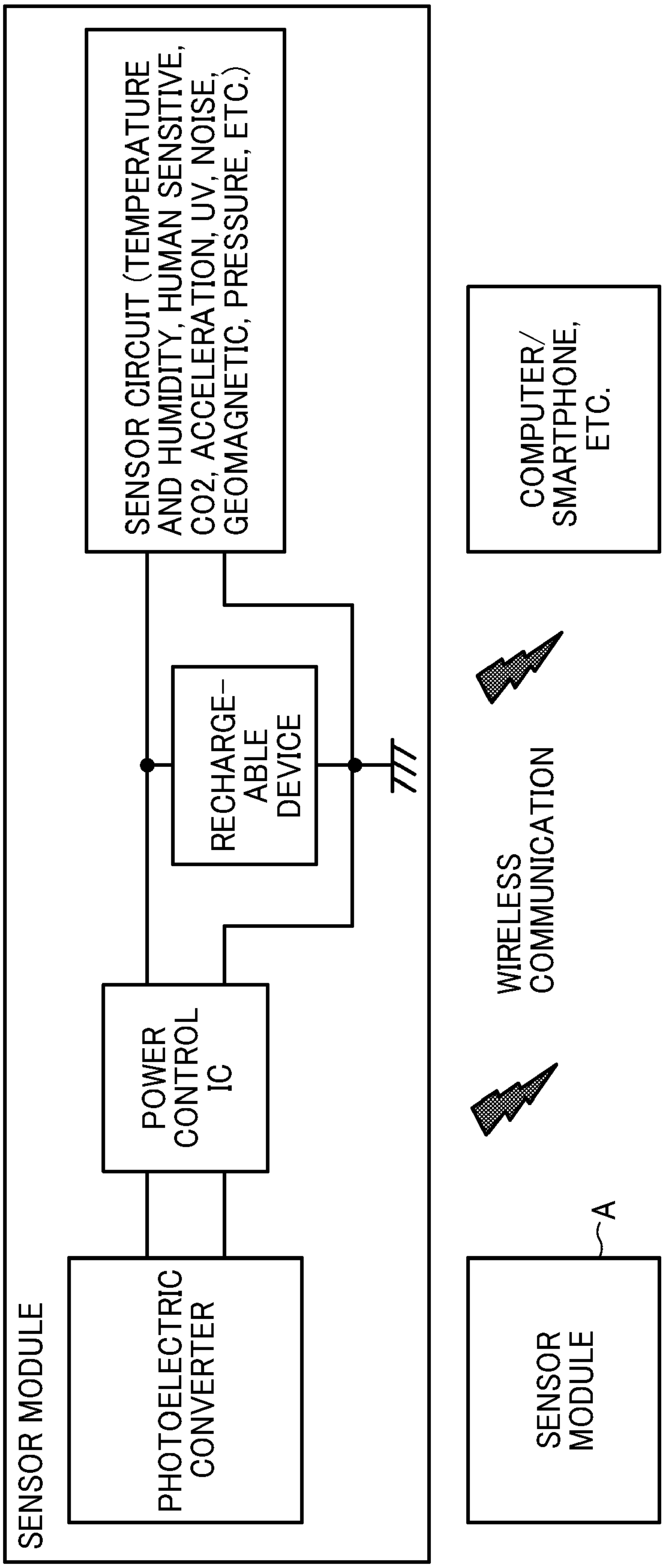
SENSOR MODULE
PHOTOELECTRIC CONVERTER
POWER CONTROL IC
RECHARGE-ABLE DEVICE
SENSOR CIRCUIT (TEMPERATURE AND HUMIDITY, HUMAN SENSITIVE, CO2, ACCELERATION, UV, NOISE, GEOMAGNETIC, PRESSURE, ETC.)
SENSOR MODULE
A
WIRELESS COMMUNICATION
COMPUTER/ SMARTPHONE, ETC.

FIG. 9

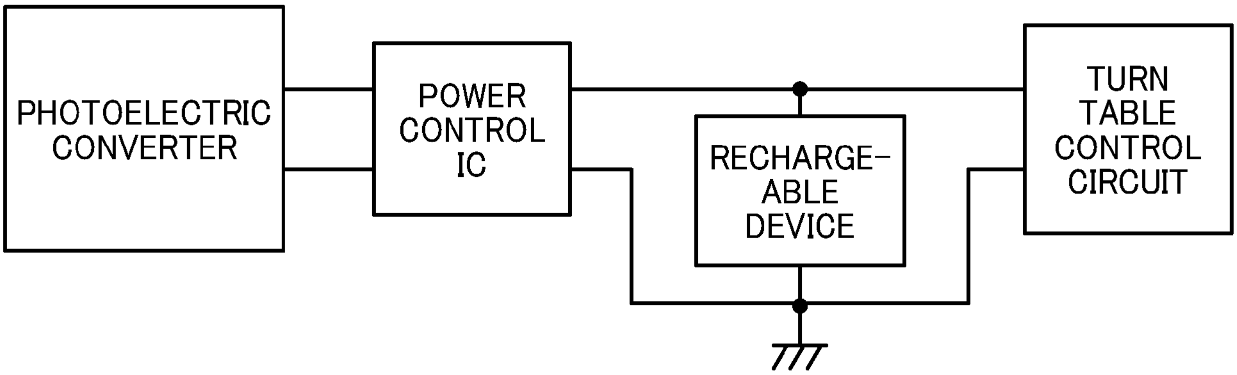


FIG. 10

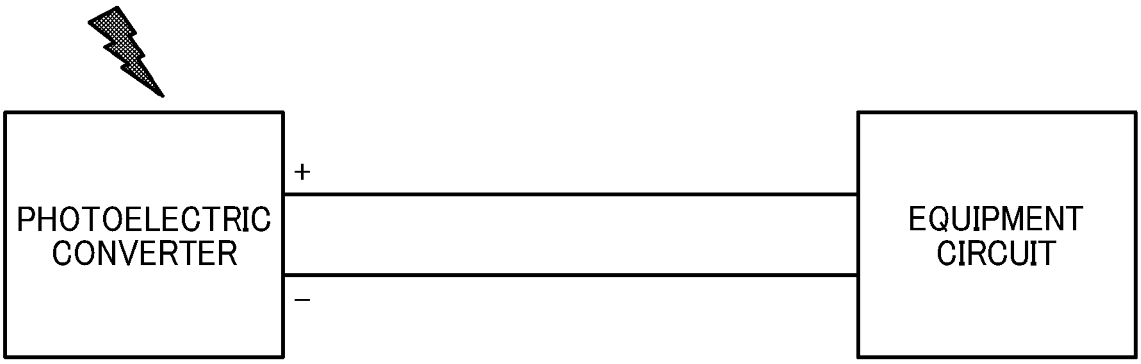


FIG. 11

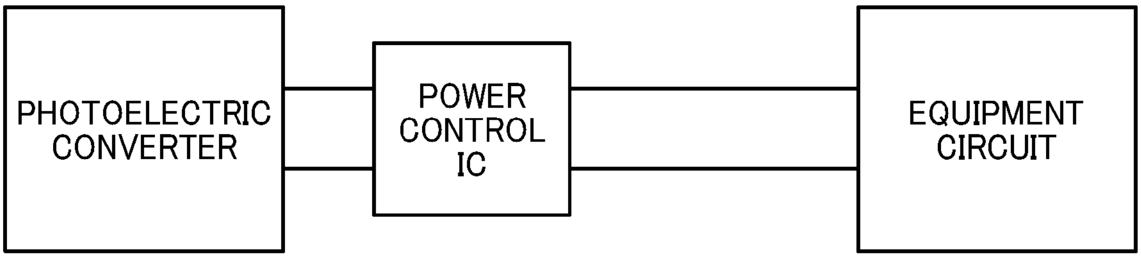

FIG. 12

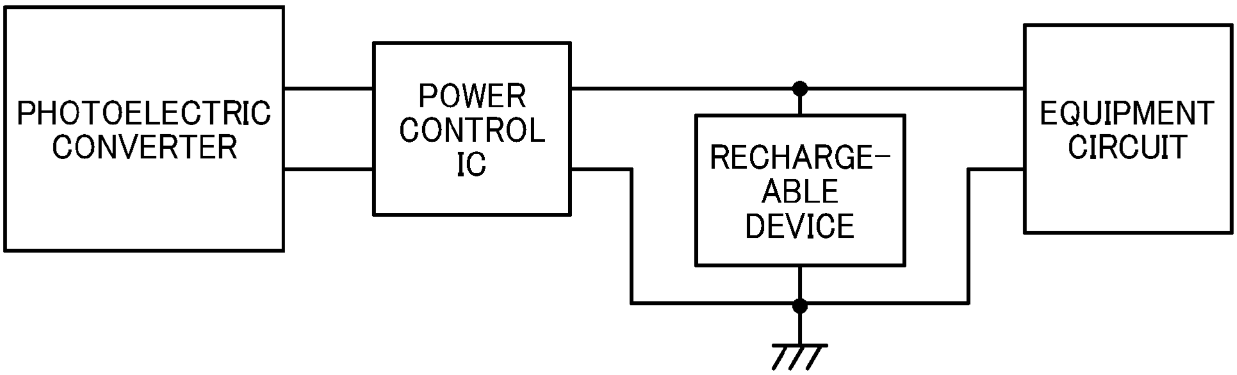


FIG. 13

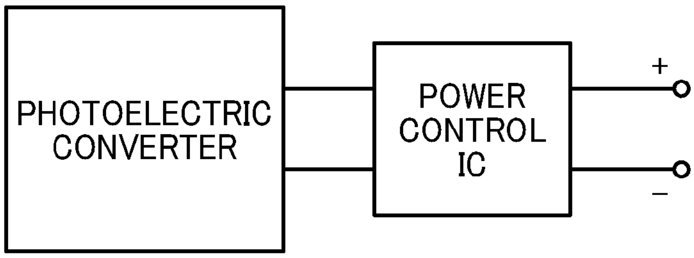


FIG. 14

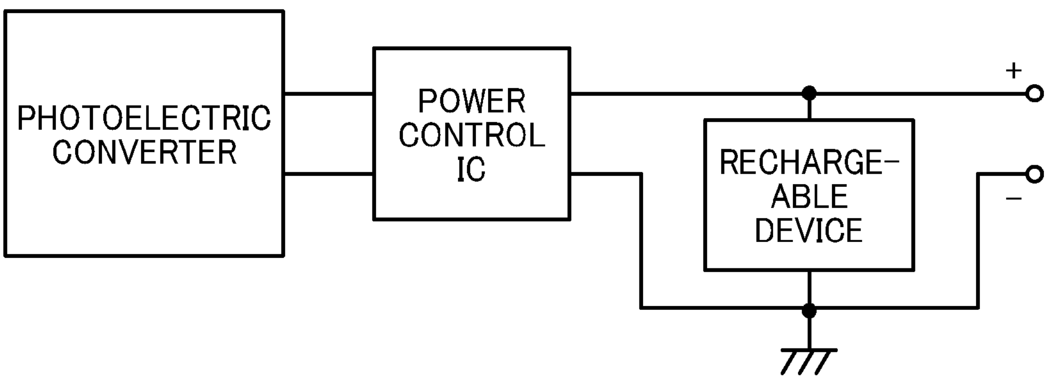

Europäisches Patentamt
European Patent Office
Office européen des brevets

# EUROPEAN SEARCH REPORT

Application Number
EP 21 15 2355

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br><br><br>Y | WO 2019/176488 A1 (RICOH CO LTD [JP]; UNIV KYUSHU NAT UNIV CORP [JP] ET AL.) 19 September 2019 (2019-09-19)<br>* paragraph [0042] *<br>* paragraph [0061] - paragraph [0064] *<br>* paragraph [0040] *<br>* paragraph [0018]; tables 1-1 *<br>* paragraph [0037] *<br>----- | 1,5-13<br><br><br>2-4 | INV.<br>H01L51/44<br>H01L51/46 |
| Y | PARK SUNG-HYUN ET AL: "Large area roll-to-roll sputtering of transparent ITO/Ag/ITO cathodes for flexible inverted organic solar cell modules", ORGANIC ELECTRONICS, ELSEVIER, AMSTERDAM, NL, vol. 30, 28 December 2015 (2015-12-28), pages 112-121, XP029403578, ISSN: 1566-1199, DOI: 10.1016/J.ORGEL.2015.12.009<br>* page 114, column 1, lines 19-21 *<br>----- | 2,4 | |
| | | | TECHNICAL FIELDS SEARCHED (IPC) |
| Y | US 2018/342701 A1 (SCHWAMB PHILIPP [DE] ET AL) 29 November 2018 (2018-11-29)<br>* paragraph [0060]; figure 1 *<br>----- | 3 | H01L |

The present search report has been drawn up for all claims

1

| Place of search | Date of completion of the search | Examiner |
|---|---|---|
| Munich | 6 May 2021 | Beierlein, Udo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 21 15 2355

This annex lists the patent family members relating to the patent documents cited in the above-mentioned European search report. The members are as contained in the European Patent Office EDP file on
The European Patent Office is in no way liable for these particulars which are merely given for the purpose of information.

06-05-2021

| Patent document cited in search report | Publication date | Patent family member(s) | Publication date |
|---|---|---|---|
| WO 2019176488 A1 | 19-09-2019 | CN 111837250 A | 27-10-2020 |
| | | EP 3766110 A1 | 20-01-2021 |
| | | JP 2019156787 A | 19-09-2019 |
| | | US 2021043846 A1 | 11-02-2021 |
| | | WO 2019176488 A1 | 19-09-2019 |
| US 2018342701 A1 | 29-11-2018 | DE 102017111519 A1 | 29-11-2018 |
| | | US 2018342701 A1 | 29-11-2018 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2014220333 A
- JP 2016208568 A


### Non-patent literature cited in the description


- *Applied Physics letters,* 2016, vol. 108, 253301
- *Japanese Journal of Applied Physics,* 2015, vol. 54, 071602